# EUROPEAN PATENT SPECIFICATION

(11) **EP 4 513 516 B1**
(45) Date of publication and mention of the grant of the patent: **17.12.2025**
(21) Application number: 24183080.1
(22) Date of filing: 19.06.2024
(51) Int. Cl.: H01C 10/50, H01C 10/36, H01C 10/48, H01H 9/02, H01H 19/04, H01H 19/10, H01H 19/14, H01C 10/32, H05B 44/00, H05B 47/10, H05B 45/10, G05G 1/10

(54) **ROTARY LIGHT SWITCH FOR A LIGHTING APPARATUS**
LICHTDREHSCHALTER FÜR EINE BELEUCHTUNGSVORRICHTUNG
COMMUTATEUR DE LUMIÈRE ROTATIF POUR UN APPAREIL D'ÉCLAIRAGE

(30) Priority: 13.07.2023 US 202363513399 P
(43) Date of publication of application: 26.02.2025
(73) Proprietor: Gantri, Inc., San Leandro, CA 94577 (US)
(72) Inventor: ROTHOLZ, Zachary, San Francisco, 94115 (US); MCCRACKEN, Nathan, San Mateo, 94404 (US); YANG, Yi, San Francisco, 94110 (US)
(74) Representative: J A Kemp LLP

(56) References cited:
- CN-A- 110 459 426
- US-A- 4 453 152
- US-A- 5 084 692
- US-A1- 2021 111 657

## Description

### TECHNICAL FIELD

The present disclosure relates generally to the field of electronic switches and, more specifically, to an improved rotary light switch for a lighting apparatus.

### BACKGROUND

Recent advances in alternative manufacturing techniques such as 3D printing or fused deposition modeling (FDM) have allowed designers to make a variety of high-quality design-centered products for the home or workplace. One popular category of design-centered products are lighting products such as table lamps, floor lamps, and wall-mounted lamps with creative and/or minimalist design features that enhance the ambience of any living or work environment.

However, while the design of the actual lighting apparatus has progressed significantly in recent years, the design of accessories accompanying such products have often stayed the same. One such lighting accessory that is in need of a design overhaul is the light switch or light dimmer used to control the luminosity or brightness of the lighting apparatus. For example, traditional light switches or dimmers are often bulky, obtrusive in design, and lacking in style. This is especially true of traditional rotary light switches or rotary light dimmers, which are often unsightly, have a dimmer button that protrudes out well beyond the body of the light switch. US2021/111657A and US4453152A disclose relevant light switches.

Therefore, an improved rotary light switch is needed which addresses the above shortcomings and disadvantages. Such a solution should not be overly complicated, should be made of components that contribute to the sleek and minimalist design of the light switch, and allow a user fine-tuned control of the lighting apparatus with a wide dimming range.

### SUMMARY

Disclosed herein is an improved rotary light switch for a lighting apparatus. In one embodiment, a rotary switch for controlling a brightness or intensity of a lighting load is disclosed. The present invention is a rotary switch for controlling a brightness or intensity of a lighting load according to claim 1, further embodiments are set out in the dependent claims. The rotary switch comprises a top switch enclosure and a bottom switch enclosure configured to be coupled to the top switch enclosure.

The top switch enclosure comprises an opening defined along a top surface of the top switch enclosure. The top switch enclosure and the bottom switch enclosure form an enclosure cavity when coupled together to form a switch enclosure.

The rotary switch comprises a printed circuit board (PCB) housed within the enclosure cavity of the switch enclosure. The rotary switch also comprises a rotary potentiometer mounted to the PCB and comprising a keyed shaft protruding through the opening of the top switch enclosure when the PCB is housed within the enclosure cavity.

The keyed shaft comprises a threaded receptacle extending partially into the keyed shaft. Rotating the keyed shaft varies a resistance of the rotary potentiometer.

The rotary switch further comprises a button chassis comprising a keyhole passage defined therethrough. The button chassis is coupled to the keyed shaft by a fastener partly screwed into the threaded receptacle. At least part of the keyed shaft protrudes into the keyhole passage when the button chassis is coupled to the keyed shaft by the fastener.

The rotary switch also comprises a button top configured to fit over and partially encapsulate the button chassis. The button top is configured to be non-detachably coupled to the button chassis when the button top is pressed onto the button chassis. Rotating the button top rotates the button chassis and keyed shaft such that the brightness or intensity of a lighting load is controllable via rotation of the button top.

In some embodiments, the button chassis can comprise a chassis body portion. The chassis body portion can be substantially shaped as a flattened cylindrical cap. The chassis body portion can comprise a chassis base and chassis lateral walls extending from the chassis base. The chassis body portion can further comprise a plurality of angled chassis projections protruding radially outward from an exterior surface of the chassis lateral walls.

The button top of the rotary switch can comprise a button top lateral wall. The button top can further comprise a plurality of angled ledge projections protruding radially inward from an interior surface of the button top lateral wall. The plurality of angled chassis projections of the button chassis can interlock with the angled ledge projections of the button top to non-detachably couple the button top to the button chassis when the button top is pressed onto the button chassis.

In some embodiments, the button chassis can also comprise a plurality of slits oriented radially around a central portion of the chassis body portion such that a radially-outer portion of the chassis body portion is divided into a plurality of petal-like sections. Each of the petal-like sections of the chassis body portion can comprise one angled chassis projection.

In some embodiments, each of the angled chassis projections can comprise a chassis projection base and a chassis projection sloped surface. Each of the angled ledge projections can comprise a ledge top surface and a ledge projection sloped surface. The ledge projection sloped surfaces of the angled ledge projections can be configured to slide against the chassis projection sloped surfaces to allow the button top to be pressed onto the button chassis. The chassis projection base and the chassis lateral wall can form an undercut for accepting the angled ledge projection and interlocking with the angled ledge projection once the ledge top surface is pressed below the chassis projection base.

In some embodiments, the button chassis can comprise a chassis body portion comprising a plurality of slits oriented radially around a central portion of the chassis body portion. Moreover, the button top can comprise a plurality of gusset supports oriented radially on the underside of the button top. At least part of the gusset supports can slide into the slits and be constrained by the slits when the button top is coupled to the button chassis. The gusset supports can be designed to translate a rotational force applied to the button top to the button chassis to rotate the button chassis.

In some embodiments, the fastener used to secure the button chassis to the keyed shaft of the rotary switch can comprise a fastener head. The keyed shaft can comprise a shaft head. In these embodiments, the rotary switch can further comprise a washer disposed in between the fastener head and the shaft head when the fastener is partly screwed into the threaded receptacle of the keyed shaft.

In some embodiments, the rotary switch, in an assembled configuration, can have a maximum switch height as measured from a top-most surface of the button top to a bottom-most surface of the bottom switch enclosure. In some embodiments, the maximum switch height can be between about 20.00 mm and about 22.00 mm (e.g., about 21.00 mm).

In some embodiments, the bottom switch enclosure can be coupled to the top switch enclosure to form an assembled switch enclosure. The assembled switch enclosure can have a maximum enclosure height as measured from the top surface of the top switch enclosure to a bottom-most surface of the bottom switch enclosure. In some embodiments, the maximum enclosure height can be between about 12.00 mm and about 14.00 mm (e.g., about 13.00 mm).

In some embodiments, the rotary switch, in an assembled configuration, can have a maximum switch width and a maximum switch length. The maximum switch width can be a maximum width of the assembled switch enclosure.

In some embodiments, the maximum switch width can be between about 37.00 mm and about 40.00 mm (e.g., about 38.00 mm). In these and other embodiments, the maximum switch length can be a maximum length of the assembled switch enclosure. The maximum switch length can be between about 61.00 mm to 65.00 mm (e.g., about 62.00 mm).

In some embodiments, the PCB of the rotary switch can comprise a cutout defined along an edge of the PCB. The rotary potentiometer can be mounted within the cutout such that at least an upper portion of the rotary potentiometer is positioned above a top surface of the PCB and a lower portion of the rotary potentiometer is positioned below a bottom surface of the PCB.

In some embodiments, keyed shaft of the rotary potentiometer can be coupled to a wiper component of the rotary potentiometer. The wiper component can be electrically coupled to a variable terminal of the rotary potentiometer. The wiper component can rotate in response to a rotation of the keyed shaft. A resistance of the rotary potentiometer can vary in response to a rotation of the wiper component.

Also disclosed is another embodiment of a rotary switch for controlling a brightness or intensity of a lighting load. The rotary switch can comprise a top switch enclosure comprising an opening defined along a top surface of the top switch enclosure and a bottom switch enclosure coupled to the top switch enclosure. The top switch enclosure and the bottom switch enclosure can form an enclosure cavity when coupled together. The rotary switch can also comprise a printed circuit board (PCB) housed within the enclosure cavity and a rotary potentiometer mounted to the PCB.

The rotary potentiometer can comprise a shaft protruding through the opening of the top switch enclosure when the PCB is housed within the enclosure cavity. Rotation of the shaft can vary a resistance of the rotary potentiometer.

The rotary switch can also comprise a button chassis comprising an enclosure-facing side. The button chassis can be coupled to the keyed shaft. The rotary switch can further comprise a first annular disk adhered to the top switch enclosure. The first annular disk can be made of an ultra-high molecular weight (UHMW) polymer. The first annular disk can encircle the opening defined along the top surface of the top switch enclosure. The rotary switch can also comprise a second annular disk adhered to the enclosure-facing side of the button chassis. The second annular disk can also be made of the UHMW polymer.

The first annular disk can contact the second annular disk to form a low-friction interface between the button chassis and the top switch enclosure when the button chassis is coupled to the keyed shaft.

The rotary switch can also comprise a button top configured to fit over and partially encapsulate the button chassis. The button top can be configured to be coupled to the button chassis. Rotating the button top can rotate the button chassis and the shaft such that the brightness or intensity of the lighting load is controllable via rotation of the button top.

In some embodiments, the UHMW polymer can be a polyethylene homopolymer.

In some embodiments, each of the first annular disk and the second annular disk can comprise a top side and a bottom side. The first annular disk can be adhered to the top switch enclosure via an acrylic adhesive applied to the bottom side of the first annular disk.

The second annular disk can be adhered to the enclosure-facing side of the button chassis via an acrylic adhesive applied to the top side of the second annular disk. The top side of the first annular disk and the bottom side of the second annular disk can form the low-friction interface between the button chassis and the top switch enclosure when the button chassis is coupled to the keyed shaft.

Also disclosed is a power cord and rotary switch assembly for controlling a brightness or intensity of a lighting load. The power cord and rotary switch assembly can comprise a top switch enclosure comprising an opening defined along a top surface of the top switch enclosure and a bottom switch enclosure. The top switch enclosure can have a distal longitudinal end and a proximal longitudinal end opposite the distal longitudinal end. The opening can be positioned closer to the proximal longitudinal end than the distal longitudinal end.

The top switch enclosure can further comprise a pair of distal securement posts positioned closer to the distal longitudinal end than the proximal longitudinal end. Each of the distal securement posts can comprise serrated protrusions extending from a lateral side of each of the distal securement posts.

The top switch enclosure can further comprise a pair of proximal securement posts positioned closer to the proximal longitudinal end than the distal longitudinal end. Each of the proximal securement posts can comprise serrated protrusions extending from a lateral side of each of the proximal securement posts. The distal securement posts and the proximal securement posts can project downward from an underside of the top switch enclosure.

The bottom switch enclosure can be configured to couple to the top switch enclosure. The top switch enclosure can be coupled to the bottom switch enclosure to form an enclosure cavity.

The power cord and rotary switch assembly can also comprise an input cord comprising an input live cable having input live wires extending therethrough and an input neutral cable having input neutral wires extending therethrough. Each of the input live cable and the input neutral cable can be secured in part within the enclosure cavity by an interference fit between an interior wall segment on an underside of the top switch enclosure and one of the distal securement posts.

The power cord and rotary switch assembly can also comprise an output cord comprising an output live cable having output live wires extending therethrough and an output neutral cable having output neutral wires extending therethrough. Each of the output live cable and the output neutral cable can be secured in part within the enclosure cavity by an interference fit between another interior wall segment on the underside of the top switch enclosure and one of the proximal securement posts.

The power cord and rotary switch assembly can also comprise a printed circuit board (PCB) housed within the enclosure cavity. The input live wires, the input neutral wires, the output live wires, and the output neutral wires can be electrically coupled to the PCB.

The power cord and rotary switch assembly can comprise a rotary potentiometer mounted to the PCB and comprising a shaft protruding through the opening of the top switch enclosure when the PCB is housed within the enclosure cavity. Rotation of the shaft can vary a resistance of the rotary potentiometer.

The power cord and rotary switch assembly can also comprise a button coupled to the keyed shaft. The shaft can rotate in response to a rotation of the button. The brightness or intensity of the lighting load can be controllable via the rotation of the button.

In some embodiments, the bottom switch enclosure of the power cord and rotary switch assembly can be coupled to the top switch enclosure to form an assembled switch enclosure. The assembled switch enclosure can comprise an input port and an output port positioned on opposite longitudinal ends of the assembled switch enclosure. At least a segment of the input cord can extend into the enclosure cavity through the input port. At least a segment of the output cord can extend into the enclosure cavity through the output port.

The segment of the input cord within the enclosure cavity can separate into the input live cable and the input neutral cable. The segment of the output cord within the enclosure cavity can separate into the output live cable and the output neutral cable. A segment of each of the input live cable, the input neutral cable, the output live cable, and the output neutral cable can be bent into an L-shaped segment within the enclosure cavity.

In some embodiments, part of the L-shaped segment of one of the input live cable or the input neutral cable can be secured to the top switch enclosure by being pressed into a distal securement space in between the interior wall segment on the underside of the top switch enclosure and one of the distal securement posts. Moreover, part of the L-shaped segment of one of the output live cable or the output neutral cable can be secured to the top switch enclosure by being pressed into a proximal securement space in between the other interior wall segment on the underside of the top switch enclosure and one of the proximal securement posts.

In some embodiments, the proximal securement space can have a proximal space width. The proximal space width can be between about 4.00 mm and 5.00 mm. The distal securement space can have a distal space width. The distal space width can be between about 4.00 mm and 5.00 mm.

In some embodiments, the top switch enclosure can comprise a distal top toothed arch and a proximal top toothed arch extending downward from the underside of the top switch enclosure. The bottom switch enclosure can comprise a distal bottom toothed arch and a proximal bottom toothed arch extending upward from the bottom switch enclosure. The distal top toothed arch and the distal bottom toothed arch can work together to clamp the segment of the input cord within the enclosure cavity. The proximal top toothed arch and the proximal bottom toothed arch can work together to clamp the segment of the output cord within the enclosure cavity.

### BRIEF DESCRIPTION OF THE DRAWINGS

Fig. 1A illustrates an exploded view of one embodiment of a rotary light switch.
Fig. 1B illustrates a perspective view of the rotary light switch in an assembled configuration.
Fig. 2A illustrates one example of a lighting apparatus that can be controlled by the rotary light switch.
Fig. 2B illustrates additional examples of lighting apparatus that can be controlled by the rotary light switch.
Figs. 3A-3C illustrate the rotary light switch in various states of assembly.
Fig. 4A illustrates a top plan view of a PCB comprising a cutout defined along an edge of the PCB.
Fig. 4B illustrates a rotary potentiometer of the rotary light switch.
Fig. 4C illustrates a side view of the rotary potentiometer mounted on part of the PCB.
Fig. 5A illustrates a perspective view of the underside of a top switch enclosure of the rotary light switch.
Fig. 5B illustrates certain electronic and electrical components of the rotary light switch secured to the top switch enclosure (which is flipped upside down in this figure) and a bottom switch enclosure of the rotary light switch separated from the top switch enclosure for ease of viewing.

### DETAILED DESCRIPTION

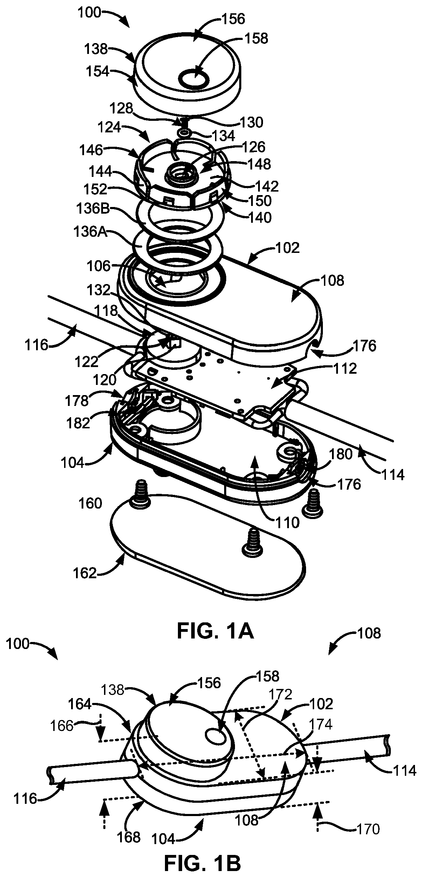

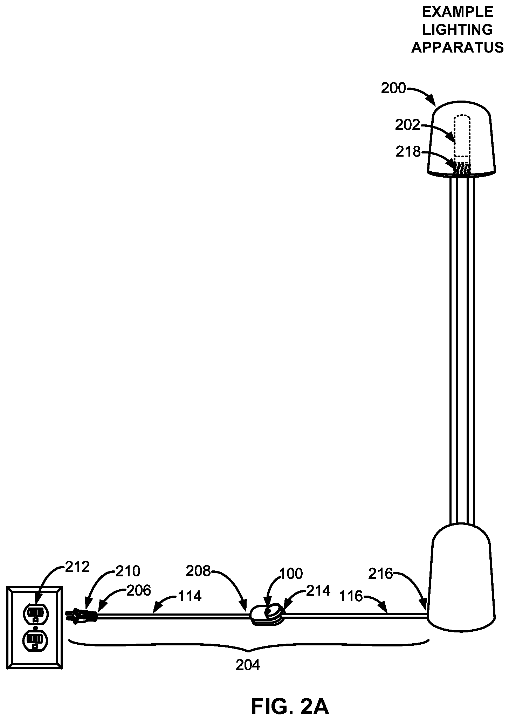

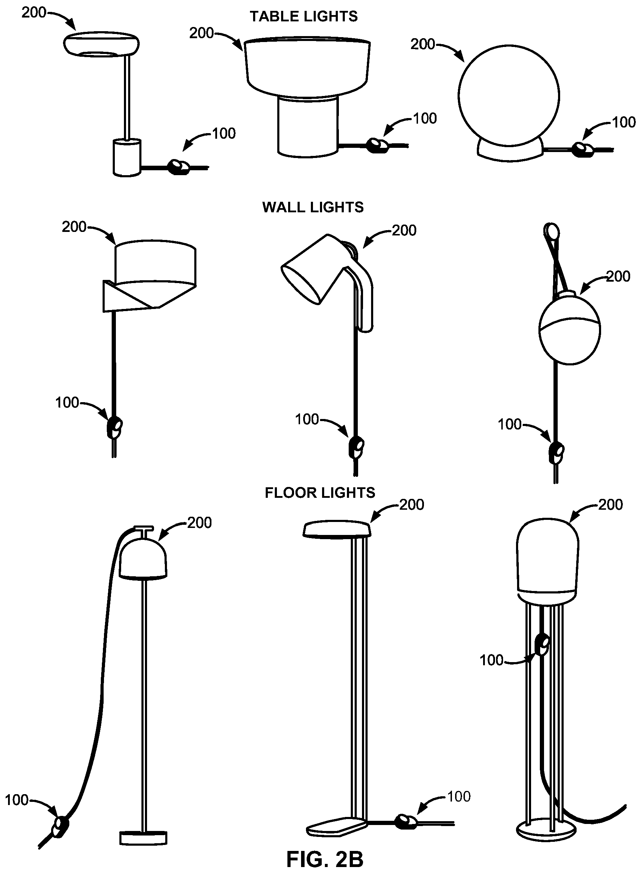

Fig. 1A illustrates an exploded view of one embodiment of a rotary switch 100. The rotary switch 100 can be used to control a brightness or intensity of a light emitting component or lighting load 202 (e.g., a light bulb) of a lighting apparatus 200 (see, e.g., Fig. 2A or 2B).

As shown in Fig. 1A, the rotary switch 100 can comprise a top switch enclosure 102 and a bottom switch enclosure 104. The top switch enclosure 102 can be coupled to the bottom switch enclosure 104 (e.g., via mechanical fasteners, adhesives, or a combination thereof) to form an assembled switch enclosure 164 (see, e.g., Fig. 1B).

The top switch enclosure 102 can have an opening 106 defined along a top surface 108 of the top switch enclosure 102. In some embodiments, the opening 106 can be a substantially circular-shaped opening.

The top switch enclosure 102 and the bottom switch enclosure 104 can form an enclosure cavity 110 when the top switch enclosure 102 is coupled to the bottom switch enclosure 104. The enclosure cavity 110 can refer to the available space within the assembled switch enclosure 164 (see, e.g., Fig. 1B).

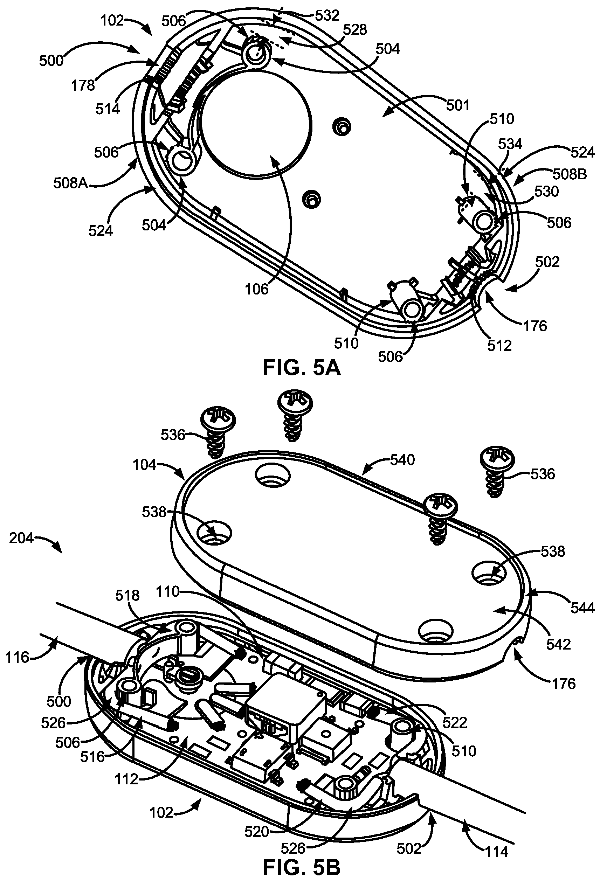

Fig. 1A also illustrates that the rotary switch 100 can comprise a printed circuit board (PCB) 112 housed or secured within the enclosure cavity 110. At least part of an input cord 114 and at least part of an output cord 116 can extend into the enclosure cavity 110 and be electrically coupled or connected to the PCB 112. The input cord 114 and the output cord 116 will be discussed in more detail in relation to Figs. 2A and 5B.

The rotary switch 100 can also comprise a rotary potentiometer 118 mounted to the PCB 112. The rotary potentiometer 118 can comprise a keyed shaft 120 configured or otherwise sized to protrude through the opening 106 of the top switch enclosure 102 when the PCB 112 is housed or secured within the enclosure cavity 110 and the top switch enclosure 102 is coupled to the bottom switch enclosure 104.

The keyed shaft 120 can also comprise a threaded receptacle 122 extending partially into the keyed shaft 120 or a body of the keyed shaft 120. As will be discussed in more detail in the following sections, the rotation of the keyed shaft 120 can vary a resistance of the rotary potentiometer 118.

The rotary switch 100 can also comprise a button chassis 124 comprising a keyhole passage 126 defined therethrough. The button chassis 124 can be coupled to the keyed shaft 120 by a fastener 128 partly screwed into the threaded receptacle 122. At least part of the keyed shaft 120 can protrude into the keyhole passage 126 when the button chassis 124 is coupled to the keyed shaft 120 by the fastener 128.

As shown in Fig. 1A, the fastener 128 can comprise a fastener head 130 and the keyed shaft 120 can comprise a shaft head 132. A washer 134 can be disposed in between the fastener head 130 and the shaft head 132 when the fastener 128 is partly screwed into the threaded receptacle 122 of the keyed shaft 120.

In some embodiments, the washer 134 can be a flat washer. The washer 134 can act as a spacer and prevent the fastener head 130 from extending completely into the keyhole passage 126. The washer 134 can also distribute the load as the fastener 128 is screwed into the threaded receptacle 122.

In some embodiments, both the washer 134 and the fastener 128 can be made of a metallic material. In certain embodiments, the keyed shaft 120 can also be made in part of a metallic material.

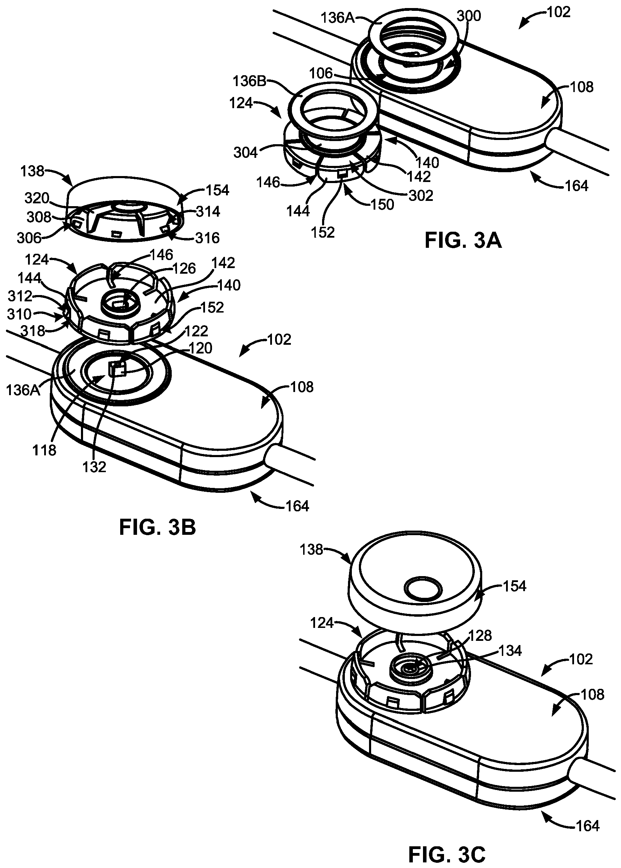

Fig. 1A also illustrates that a first annular disk 136A and a second annular disk 136B can be disposed in between the top surface 108 of the top switch enclosure 102 and an enclosure-facing side 302 (see, e.g., Fig. 3A) of the button chassis 124 when the button chassis 124 is coupled to the keyed shaft 120 via the fastener 128. The first annular disk 136A and the second annular disk 136B can serve as an interface between the button chassis 124 and the top surface 108 of the top switch enclosure 102. For example, a top side of the first annular disk 136A can physically contact or rub against a bottom side of the second annular disk 136B when the button chassis 124 is rotated.

Each of the first annular disk 136A and the second annular disk 136B can be made in part of a material that is defined by a smooth surface texture or can be processed to have a smooth surface texture. Each of the first annular disk 136A and the second annular disk 136B can be made in part of a lubricious material. For example, each of the first annular disk 136A and the second annular disk 136B can be made in part of an ultra-high molecular weight (UHMW) polymer (e.g., a polyethylene (PE) homopolymer or polytetrafluoroethylene (PTFE)). The first annular disk 136A and the second annular disk 136B will be discussed in more detail in relation to Figs. 3A-3C.

The rotary switch 100 can further comprise a button top 138 configured to fit over and partially encapsulate the button chassis 124. In some embodiments, the button top 138 can be configured to be non-detachably or persistently coupled to the button chassis 124 when the button top 138 is pressed onto the button chassis 124. Once the button top 138 is non-detachably or persistently coupled to the button chassis 124 by being pressed onto the button chassis 124, any rotation (e.g., clockwise or counterclockwise rotation) of the button top 138 will also rotate the button chassis 124 and the keyed shaft 120 such that the brightness or intensity of the lighting load 202 (see, e.g., Fig. 2A) is controllable via rotation of the button top 138.

As shown in Fig. 1A, the button chassis 124 can comprise a chassis body portion 140. The chassis body portion 140 can be substantially shaped as a flattened cylindrical cap. In other embodiments, the chassis body portion 140 can be substantially shaped as a circular disk with raised edges extending vertically upward around a periphery or circumference of the circular disk or near the periphery or circumference of the circular disk.

The chassis body portion 140 can comprise a chassis base 142 and chassis lateral walls 144 extending vertically from the chassis base 142. The button chassis 124 can further comprise a plurality of slits 146 oriented radially around a central portion 148 of the chassis body portion 140. The slits 146 can be arranged or positioned such that a radially-outer portion (i.e., a portion radially outward of the central portion 148) of the chassis body portion 140 is divided into a plurality of petal-like sections 150.

The chassis body portion 140 can further comprise a plurality of angled chassis projections 152. The angled chassis projections 152 can protrude radially outward from an exterior surface of the chassis lateral walls 144. As shown in Fig. 1A, each of the petal-like sections 150 of the chassis body portion 140 can comprise one angled chassis projection 152.

In other embodiments, each of the petal-like sections 150 of the chassis body portion can comprise two or more angled chassis projections 152. In further embodiments, only some of the petal-like sections 150 can comprise an angled chassis projection 152 (e.g., every other petal-like section 150).

As seen in Fig. 1A, the button top 138 can comprise a button top lateral wall 154. As will be discussed in more detail in relation to Fig. 3B, the button top 138 can further comprise a plurality of angled ledge projections 306 protruding radially inward from an interior surface 308 of the button top lateral wall 154. The plurality of angled chassis projections 152 of the button chassis 124 can interlock with the angled ledge projections 306 of the button top 138 to non-detachably or persistently couple the button top 138 to the button chassis 124 when the button top 138 is pressed onto the button chassis 124 during the assembly of the rotary switch 100.

Fig. 1A also illustrates that a top surface 156 of the button top 138 can comprise a divot or concave portion 158. The divot or concave portion 158 can allow a user to visually track the rotation (e.g., clockwise or counterclockwise) of the button top 138. For example, a user operating the rotary switch 100 to control a brightness of a lighting apparatus 200 (see, e.g., Figs. 2A and 2B) can use the current position or orientation of the divot or concave portion 158 to determine whether the lighting apparatus 200 is turned on or off and whether the lighting apparatus 200 is at its maximum brightness or somewhere in between an off position and maximum brightness.

Although not shown in the figures, the button top 138 can also be partially encapsulated or covered by a button overmold or overmold layer. The button overmold can be an outer layer that is applied to the top surface 156 and at least part of the exterior surface of the button top lateral wall 154 by an overmolding process. For example, the button overmold can be made by an injection molding process. In some embodiments, the button overmold can be a thermoplastic elastomer. The button overmold can allow a user to more easily grip or grasp the button top 138 in order to rotate the button top 138.

Fig. 1A further illustrates that the top switch enclosure 102 can be secured, fastened, or otherwise coupled to the bottom switch enclosure 104 via a plurality of mechanical fasteners 160. In some embodiments, the mechanical fasteners 160 can be threaded screws or bolts.

In other embodiments, the mechanical fasteners 160 can be clips or magnetic-type fasteners.

In further embodiments, the top switch enclosure 102 can be secured or coupled to the bottom switch enclosure 104 via an adhesive or a combination of an adhesive and mechanical fasteners 160.

The rotary switch 100 can also comprise an anti-slip pad 162 or anti-slip layer affixed or otherwise coupled to a bottom side 540 (see, e.g., Fig. 5B) of the bottom switch enclosure 104. In some embodiments, the bottom side 540 of the bottom switch enclosure 104 can comprise a depression 542 or be set in from an outer edge 544 of the bottom switch enclosure 104 (see, e.g., Fig. 5B). This can allow the anti-slip pad 162 or anti-slip layer to be affixed or otherwise coupled (e.g., via adhesives) to the depression 542 but still be flush with the outer edge 544 of the bottom side 540 of the bottom switch enclosure 104.

In some embodiments, the anti-slip pad 162 can be made in part of a thermoplastic elastomer or thermoplastic polyurethane. In further embodiments, the anti-slip pad 162 can be made of rubber or synthetic rubber.

Fig. 1B illustrates a perspective view of the rotary switch 100 in an assembled configuration. For example, the top switch enclosure 102 can be coupled to the bottom switch enclosure 104 (e.g., via mechanical fasteners, adhesives, or a combination thereof) to form an assembled switch enclosure 164 (see, e.g., Fig. 1B). When the rotary switch 100 is in the assembled configuration, the button chassis 124 can be coupled to the keyed shaft 120 of the rotary potentiometer 118. At least part of the keyed shaft 120 can extend into the keyhole passage 126 of the button chassis 124 and the button chassis 124 can be further coupled to the keyed shaft 120 by the fastener 128 screwed into the threaded receptacle 122 of the keyed shaft 120 (see, e.g., Fig. 1A).

The button top 138 can be non-detachably or persistently coupled to the button chassis 124 when the button top 138 is pressed onto the button chassis 124 as part of the assembly procedure for the rotary switch 100. When the rotary switch 100 is in the assembled configuration, rotating the button top 138 can rotate the button chassis 124 under the button top 138 and also rotate the keyed shaft 120 coupled to the button chassis 124. As will be discussed in more detail in the following sections, rotation of the keyed shaft 120 can vary a resistance of the rotary potentiometer 118 which can affect the brightness or intensity of the lighting load 202 of the lighting apparatus 200 (see, e.g., Fig. 2A).

When the rotary switch 100 is in the assembled configuration, the rotary switch 100 can have a maximum switch height 166 or maximum thickness as measured from the top surface 156 or a top-most surface of the button top 138 to a bottom-most surface 168 of the bottom switch enclosure 104.

In some embodiments, the maximum switch height 166 or maximum thickness can be between about 20.00 mm and about 22.00 mm. For example, the maximum switch height 166 or maximum thickness of the rotary switch 100 can be about 21.0 mm.

Moreover, the assembled switch enclosure 164 can have a maximum enclosure height 170 as measured from the top surface 108 of the top switch enclosure 102 to the bottom-most surface 168 of the bottom switch enclosure 104.

In some embodiments, the maximum enclosure height 170 can be between about 12.00 mm and about 14.00 mm. For example, the maximum enclosure height 170 can be about 13.0 mm.

Moreover, the rotary switch 100 can also have a maximum switch width 172 and a maximum switch length 174. The maximum switch width 172 can be a maximum width of assembled switch enclosure 164. The maximum switch length 174 can be a maximum length of the assembled switch enclosure 164.

In some embodiments, the maximum switch width 172 can be between about 37.00 mm and about 40.00 mm. For example, the maximum switch width 172 can be about 38.0 mm.

The maximum switch length 174 can be between about 61.00 mm to 65.00 mm. For example, the maximum switch length 174 can be about 62.0 mm.

One technical problem faced by the applicants is how to make a physical rotary switch that is visually appealing and is minimalist in its design and form factor. For example, most traditional physical rotary switches are often bulky and obtrusive in the overall look and feel of the rotary switch. The rotary switch 100 disclosed herein is an advancement/improvement in the field of physical rotary switches given the small size and reduced profile of the switch. As can be seen from Fig. 1A, the specially-designed components of the rotary switch 100 allow a user to rotate only one low-profile button that is coupled to a low-profile switch enclosure with all other components hidden by the button top 138 and the assembled switch enclosure 164. Moreover, despite the small size and minimalist look of the rotary switch 100, the rotary switch 100 provides a wide dimming range and allows a user to finely-tune the brightness of a lighting load.

As shown in Figs. 1A and 1B, the assembled switch enclosure 164, as well as the top switch enclosure 102 and the bottom switch enclosure 104, can be substantially obround-shaped or resemble the shape of a stadium. For example, the assembled switch enclosure 164, as well as the top switch enclosure 102 and the bottom switch enclosure 104, can have a substantially rectangular middle-section and semicircular sides or rounded sides at each longitudinal end.

In some embodiments, the top switch enclosure 102, the bottom switch enclosure 104, the button chassis 124 and the button top 138 can all be made of a polymeric material. For example, the top switch enclosure 102, the bottom switch enclosure 104, the button chassis 124 and the button top 138 can all be made of polylactic acid (PLA). More specifically, the top switch enclosure 102, the bottom switch enclosure 104, the button chassis 124 and the button top 138 can all be made of a plant-based PLA.

In other embodiments, at least one of the top switch enclosure 102, the bottom switch enclosure 104, the button chassis 124 and the button top 138 can be made of PLA, acrylonitrile butadiene styrene (ABS), polystyrene (PS), nylon, polyethylene terephthalate (PET), polyethylene terephthalate glycol (PETG), polycarbonate (PC), and/or polypropylene (PP).

In further embodiments, at least one of the top switch enclosure 102, the bottom switch enclosure 104, the button chassis 124 and the button top 138 can be made of a metallic material, an organic material (e.g., wood), or a ceramic material.

In further embodiments, the top switch enclosure 102, the bottom switch enclosure 104, the button chassis 124 and the button top 138 can all be made by a 3D-printing process. In additional embodiments, at least one of the top switch enclosure 102, the bottom switch enclosure 104, the button chassis 124 and the button top 138 can be made by a 3D-printing process.

In additional embodiments, at least one of the top switch enclosure 102, the bottom switch enclosure 104, the button chassis 124 and the button top 138 can be 3D-printed using a metal-infused material (e.g., copper, bronze, brass, or stainless steel infused 3D printing filament) and/or a wood-filled material (e.g., a PLA base material with wood dust, cork, or powdered wood derivatives infused into the base material).

In other embodiments, at least one of the top switch enclosure 102, the bottom switch enclosure 104, the button chassis 124 and the button top 138 can be made by a traditional manufacturing technique such as injection-molding or cast-molding.

Fig. 2A illustrates one example of a lighting apparatus 200 that can be controlled by the rotary switch 100. As shown in Fig. 2A, the lighting apparatus 200 can be a floor lamp or floor light.

The lighting apparatus 200 can comprise a light emitting component or lighting load 202. The light emitting component or lighting load 202 is shown in broken/phantom lines in Fig. 2A since the light emitting component or lighting load 202 is often obscured or at least partially covered by a lamp shade of the lighting apparatus 200.

In some embodiments, the light emitting component or lighting load 202 can be a light-emitting diode (LED) bulb or an LED strip. For example, the light emitting component or lighting load 202 can be an 8.5-watt E26 LED bulb or a 6-watt E12 LED bulb. In other embodiments, the light emitting component or lighting load 202 can be an incandescent light bulb or a compact fluorescent light bulb.

The rotary switch 100 can control a brightness of the light emitting component or lighting load 202 (e.g., the LED bulb). As shown in Fig. 2A, the rotary switch 100 can be provided or otherwise included as part of a power cord and rotary switch assembly 204.

In some embodiments, the power cord and rotary switch assembly 204 can comprise the input cord 114 and the output cord 116 electrically coupled or connected to the rotary switch 100. The input cord 114 can comprise a distal input cord end 206 and a proximal input cord end 208. An electrical plug 210 can be electrically connected or otherwise coupled to the distal input cord end 206 of the input cord 114. For example, the electrical plug 210 can be a polarized multi-pronged electrical plug (e.g., a Type-A plug) for plugging into a wall receptacle 212 (e.g., a polarized wall receptacle).

The proximal input cord end 208 can extend into the assembled switch enclosure 164 of the rotary switch 100. More specifically, electrical wires extending from the proximal input cord end 208 can be electrically connected or coupled to the PCB 112 of the rotary switch 100.

The output cord 116 can comprise a distal output cord end 214 and a proximal output cord end 216. The distal output cord end 214 can extend into the assembled switch enclosure 164 of the rotary switch 100. More specifically, electrical/conductive wires extending from the distal output cord end 214 can be electrically connected or coupled to the PCB 112 of the rotary switch 100.

The proximal output cord end 216 or electrical/conductive wires extending from the proximal output cord end 216 can be electrically coupled or connected to a light socket 218 of the lighting apparatus 200. For example, the proximal output cord end 216 or the electrical wires extending from the proximal output cord end 216 can be electrically coupled or connected to conductive clamps or other conductive securement mechanisms of the light socket 218 (e.g., a E26 or E12 light socket) of the lighting apparatus 200.

Fig. 2B illustrates that the rotary switch 100 can be used to control different types of floor lights or floor lamps as well as table lights or table lamps and wall lights or wall lamps.

In some embodiments, the lighting apparatus 200 can be any of the lighting apparatus or lamps disclosed in U.S. Patent Publication No. US2022/0308552.

Each of the lights or lamps shown in Fig. 2B can comprise at least one light emitting component or lighting load 202. The rotary switch 100 can be used to control the brightness of the light emitting component or lighting load 202 of each of the lights or lamps.

Figs. 3A-3C illustrate the rotary switch 100 in various states of assembly. As shown in Figs. 3A-3C, a first annular disk 136A can be adhered or otherwise affixed to a receiving space 300 defined along the top surface 108 of the top switch enclosure 102.

As shown in Fig. 3A, the receiving space 300 can be substantially shaped to complement the shape of the first annular disk 136A. For example, the receiving space 300 can be substantially annular shaped. In other embodiments, the receiving space 300 can be circular.

The receiving space 300 can be slightly set in or lower than the top surface 108 of the top switch enclosure 102. For example, the receiving space 300 can be an annular depression defined along the top surface 108 of the top switch enclosure 102. The receiving space 300 can surround the opening 106 defined along the top surface 108 of the top switch enclosure 102.

In some embodiments, the depth or height of the receiving space 300 can be substantially equivalent to the thickness or height of the first annular disk 136A. For example, the depth or height of the receiving space 300 and the thickness or height of the first annular disk 136A can be between about 0.45 mm and 0.60 mm (e.g., about 0.55 mm).

In certain embodiments, the depth or height of the receiving space 300 can be slightly less than or slightly greater than the thickness or height of the first annular disk 136A.

As previously discussed, one side of the first annular disk 136A can have an adhesive (e.g., an acrylic adhesive) applied to an underside of the first annular disk 136A such that the first annular disk 136A can be adhered to the receiving space 300 (which can also have an adhesive applied thereto in some embodiments). When the first annular disk 136A is placed within and adhered to the receiving space 300, the first annular disk 136A can surround or encircle the opening 106 (e.g., the circular opening) defined along the top surface 108 of the top switch enclosure 102.

The first annular disk 136A can be made, at least in part, of a lubricious material or a material having a smooth surface texture or a surface having a low coefficient of friction. This allows the exposed side of the first annular disk 136A or the side opposite the adhered side to serve as a low-friction surface for interfacing with the second annular disk 136B that is coupled to the button chassis 124.

For example, the first annular disk 136A can be made, at least in part, of an ultra-high molecular weight (UHMW) polymer. For example, the UHMW polymer can be a polyethylene homopolymer. In other embodiments, the first annular disk 136A can be made, at least in part, of PTFE. In further embodiments, the exposed side of the first annular disk 136A can be covered by a lubricous coating.

As shown in Fig. 3A, the second annular disk 136B can be adhered to an enclosure-facing side 302 of the button chassis 124. The enclosure-facing side 302 can be an underside of the button chassis 124.

The enclosure-facing side 302 can comprise a concentric protrusion 304 projecting from the underside of the chassis base 142. The concentric protrusion 304 can be a flattened cylindrical-shaped portion that extends further below the chassis body portion 140 of the button chassis 124.

The second annular disk 136B can be adhered to a radially outer surface of the enclosure-facing side 302 that surrounds or encircles the concentric protrusion 304.

Similar to the first annular disk 136A, one side of the second annular disk 136B can have an adhesive (e.g., an acrylic adhesive) applied to the second annular disk 136B such that the second annular disk 136B can be adhered to the enclosure-facing side 302 (which can also have an adhesive applied thereto in some embodiments). When the second annular disk 136B is adhered to the enclosure-facing side 302, the second annular disk 136B can surround or encircle the concentric protrusion 304. In some embodiments, the second annular disk 136B can be sized similar to the first annular disk 136A.

The second annular disk 136B can be made, at least in part, of a lubricious material or a material having a smooth surface texture or a surface having a low coefficient of friction. This allows the exposed side of the second annular disk 136B or the side opposite the adhered side to serve as a low-friction surface for interfacing with the first annular disk 136A adhered to the receiving space 300 on the top switch enclosure 102.

For example, the second annular disk 136B can be made, at least in part, of an ultra-high molecular weight (UHMW) polymer. For example, the UHMW polymer can be a polyethylene homopolymer. In other embodiments, the second annular disk 136B can be made, at least in part, of PTFE. In further embodiments, the exposed side of the second annular disk 136B can be covered by a lubricous coating.

The first annular disk 136A and the second annular disk 136B can be disposed in between the top surface 108 of the top switch enclosure 102 and the enclosure-facing side 302 of the button chassis 124 when the button chassis 124 is coupled to the keyed shaft 120 (see, e.g., Fig. 3B) via the fastener 128. Moreover, the concentric protrusion 304 of the button chassis 124 can be positioned at least partly within the opening 106 of the top switch enclosure 102 when the button chassis 124 is coupled to the keyed shaft 120. This can allow the top side of the first annular disk 136A to physically contact or rub against the bottom side of the second annular disk 136B when the button chassis 124 is rotated. The first annular disk 136A and the second annular disk 136B can serve as a low-friction interface between the button chassis 124 and the top surface 108 of the top switch enclosure 102. The first annular disk 136A and the second annular disk 136B can allow the button chassis 124 to turn or rotate effortlessly without the components having to be oiled constantly.

Fig. 3B illustrates that the chassis body portion 140 can further comprise a plurality of angled chassis projections 152. The angled chassis projections 152 can protrude radially outward from an exterior surface of the chassis lateral walls 144. As shown in Fig. 3B, each of the petal-like sections 150 of the chassis body portion 140 can comprise one angled chassis projection 152.

In other embodiments, each of the petal-like sections 150 of the chassis body portion can comprise two or more angled chassis projections 152. In further embodiments, only some of the petal-like sections 150 can comprise an angled chassis projection 152 (e.g., every other petal-like section 150).

Fig. 3B also illustrates that the button top 138 can be substantially shaped as cylindrical cap comprising a top surface 156 and a button top lateral wall 154 extending vertically downward. As shown in Fig. 3B, the button top 138 can further comprise a plurality of angled ledge projections 306 protruding radially inward from an interior surface 308 of the button top lateral wall 154. The plurality of angled chassis projections 152 of the button chassis 124 can interlock with or push against the angled ledge projections 306 of the button top 138 to non-detachably or persistently couple the button top 138 to the button chassis 124 when the button top 138 is pressed onto the button chassis 124 during the assembly of the rotary switch 100.

Each of the angled chassis projections 152 can comprise a chassis projection base 310 and a chassis projection sloped surface 312. Moreover, each of the angled ledge projections 306 can comprise a ledge top surface 314 and a ledge projection sloped surface 316.

For example, each of the angled chassis projections 152 can be substantially shaped as a miniature triangular prism (e.g., a right triangular prism) with the chassis projection sloped surface 312 being the longest triangular side (or the hypotenuse) of the triangular prism and the chassis projection base 310 being the shortest triangular side of the triangular prism. The chassis projection sloped surface 312 can meet the exterior of the chassis lateral walls 144 at an acute angle and the chassis projection base 310 can project radially outward from the chassis lateral wall 144. The chassis projection base 310 and the chassis lateral wall 144 can form an undercut 318 for accepting one of the angled ledge projections 306.

Moreover, each of the angled ledge projections 306 can also be substantially shaped as a miniature triangular prism (e.g., a right triangular prism) with the ledge projection sloped surface 316 being the longest triangular side (or the hypotenuse) of the triangular prism and the ledge top surface 314 being the shortest triangular side of the triangular prism. The ledge projection sloped surface 316 can meet interior surface 308 of the button top 138 at an acute angle and the ledge top surface 316 can project radially outward from the interior surface 308.

The ledge projection sloped surfaces 316 of the angled ledge projections 306 can be configured to slide against the chassis projection sloped surfaces 312 to allow the button top 138 to be pressed onto the button chassis 124. Once the button top 138 is pressed onto the button chassis 124, the undercut 318 formed by the chassis projection base 310 and the chassis lateral wall 144 can accept the ledge top surface 314 of the angled ledge projection 306 and the angled chassis projections 152 can interlock with the angled ledge projections 306 to non-detachably or persistently couple the button top 138 to the button chassis 124.

Each of the petal-like sections 150 of the button chassis 124 can bend or be pushed radially-inward as the button top 138 is pressed onto the button chassis 124 to allow the button top 138 to be pressed onto the button chassis 124.

Fig. 3B also illustrates that the button top 138 can comprise a plurality of gusset supports 320 oriented radially on an underside of the button top 138. At least part of the gusset supports 320 can be positioned within and constrained by the radially-oriented slits 146 when the button top 138 is coupled to the button chassis 124. The gusset supports 320 can be designed to translate a rotational force applied to the button top 138 to the button chassis 124 to rotate the button chassis 124. The gusset supports 320 can also structurally support the button top 138.

Therefore, the radially-oriented slits 146 of the button chassis 124 serve multiple functions. One is to divide up the chassis body portion 140 into a plurality of petal-like sections 150 such that the petal-like sections 150 can bend or be pushed radially inward when the button top 138 is pressed onto the button chassis 124. Another function is to serve as guides to correctly orient the button top 138 with respect to the button chassis 124. Yet another function is to serve as a receiving space for the gusset supports 320.

When the button top 138 is non-detachably or persistently coupled to the button chassis 124, a user can rotate the button chassis 124 by simply rotating the button top 138. Since the button chassis 124 is coupled to the keyed shaft 120 of the rotary potentiometer 118, rotating the button chassis 124 can rotate the keyed shaft 120 which can vary the resistance of the rotary potentiometer 118. As such, rotating the button top 138 can vary the brightness or intensity of the lighting load 202 of the lighting apparatus 200 (see, e.g., Figs. 2A and 2B).

Fig. 3B also illustrates that the keyed shaft 120 can be shaped substantially as a rectangular prism. In some embodiments, the shorter sides of the keyed shaft 120 can be curved or rounded. For example, the keyed shaft 120 can have two longer parallel sides and two curved or rounded shorter sides.

The keyed shaft 120 can also have a shaft height. The shaft height can be between about 1.0 mm and 2.0 mm. For example, the shaft height can be about 1.2 mm, 1.5 mm, or 1.75 mm.

Fig. 3C illustrates that the button top 138 can fit over and partially encapsulate the button chassis 124. Fig. 3C also illustrates that the button chassis 124 can be coupled to the keyed shaft 120 (which extends through the keyhole passage 126, see, e.g., Fig. 3B) by a fastener 128 partly screwed into the threaded receptacle 122 of the keyed shaft 120. A washer 134 can also be disposed in between the fastener 128 and the shaft head 132 of the keyed shaft 120 (see, e.g., Fig. 3B) when the fastener 128 is screwed into the threaded receptacle 122 of the keyed shaft 120.

When the button top 138 is pressed onto the button chassis 124, the button top 138 is then non-detachably or persistently coupled to the button chassis 124. At this point, the button top 138 can only be removed from the button chassis 124 by prying the button top 138 off of the button chassis 124 (which will likely result in damaging at least part of the button top 138 or button chassis 124). Therefore, once the button top 138 is pressed onto the button chassis 124, the button top 138 is then secured to the button chassis 124. This prevents a user from inadvertently disassembling the rotary switch 100. Moreover, once the button top 138 is coupled to the button chassis 124, no fasteners or screws or other components under the button top 138 are visible to the user. By designing the rotary switch 100 in this manner, the rotary switch 100 is aesthetically pleasing and is minimalist in its outer appearance.

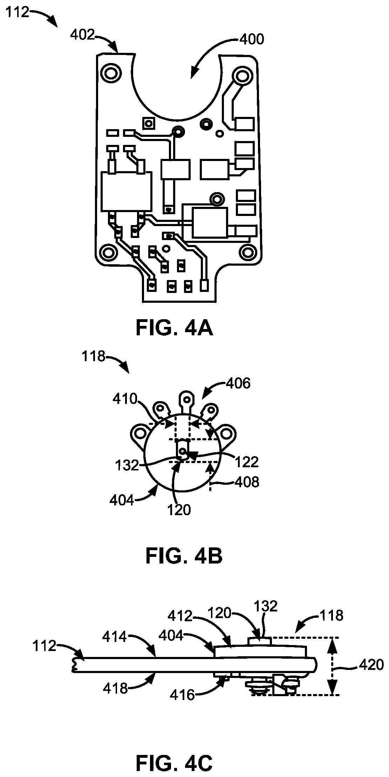

Fig. 4A illustrates a top plan view of one embodiment of the PCB 112 of the rotary switch 100. The PCB 112 can comprise a cutout 400 defined along an edge 402 of the PCB 112. In some embodiments, the PCB 112 can be a rigid PCB made of polyimide. In other embodiments, the PCB 112 can be a flexible PCB or a flexible-rigid PCB.

In some embodiments, the cutout 400 can be made by milling or cutting part of the edge 402 of the PCB using a milling machine or rotary cutter.

As shown in Fig. 4A, the cutout 400 can be substantially circular-shaped or shaped as a partial circle (e.g., a three-quarters circle or semicircle). The cutout 400 can be sized to allow the rotary potentiometer 118 to fit within at least part of the cutout 400.

Fig. 4B illustrates a top plan view of the rotary potentiometer 118 of the rotary switch 100. The rotary potentiometer 118 can be a low-profile potentiometer comprising a molded case 404. In some embodiments, the molded case 404 can be shaped substantially as a flattened cylinder. The molded case 404 can have a case diameter of between 12.00 mm and 18.00 mm (e.g., about 16.00 mm). The molded case 404 of the rotary potentiometer 118 can house at least part of a wiper component connected to the keyed shaft 120. Rotation of the keyed shaft 120 can rotate the wiper component. The molded case 404 can also partially house several pins or terminals 406.

The rotary potentiometer 118 (including the pins or terminals 406 of the potentiometer) can be electrically connected or coupled to electrical circuitry and electronic components mounted on the PCB 112. The rotary potentiometer 118 can provide a variable resistance between two or more of the pins or terminals 406 in response to a rotation of the wiper component (the rotation of which is connected to the rotation of the keyed shaft 120). The wiper component can be electrically coupled to a variable terminal of the rotary potentiometer 118.

In some embodiments, the rotary switch 100 can comprise a number of other electronic and electrical components in addition to the rotary potentiometer 118. For example, the rotary switch 100 can comprise a semiconductor switch such as a triac, a diac, a series resistor in between the diac and the triac, a capacitor, a bridge rectifier, a number of rectifier resistors, a snubber resistor, a snubber cap, an inductor filter, and a fuse component. All such components of the rotary switch 100 can be mounted to the PCB 112 along with the rotary potentiometer 118.

In some embodiments, the triac can be replaced by one or more bidirectional switches. For example, the switches can comprise one or more field-effect transistors or insulated gate bipolar junction transistors.

The rotary switch 100 can operate based on a forward phase-control dimming technique where the rotary potentiometer 118 renders a semiconductor switch (e.g., the triac of the rotary switch 100) conductive for a portion of a line half-cycle to provide power to the lighting load 202 and renders the triac non-conductive for the other portion of the line half-cycle to prevent current form flowing to the lighting load 202. The ratio of the length of time during which the semiconductor switch is conductive to the length of time during which the semiconductor switch is non-conductive determines the intensity or brightness of the light produced by the lighting load 202. The rotary potentiometer 118 can control how long it takes for the capacitor to reach a set voltage that turns on the triac.

Within the molded case 404 of the rotary potentiometer 118, the rotary potentiometer 118 can comprise a rotatable wiper component that rotates around a resistive track or strip. At one end of the resistive track or strip is a first terminal and at the other end of the resistive track is a second terminal. The wiper component can be electrically coupled to a variable terminal of the rotary potentiometer 118. The wiper component can be rotated (e.g., in a clockwise or counterclockwise direction) by the keyed shaft 120 such that the resistance of the rotary potentiometer 118 varies based on the positioning of the wiper component relative to the first terminal and the second terminal.

In some embodiments, when the wiper component and the keyed shaft 120 are turned or rotated fully in the clockwise direction (when looking down at the rotary potentiometer 118), the resistance of the rotary potentiometer 118 is at its lowest and the triac turns on rather quickly and is rendered conductive. However, when the wiper component and the keyed shaft 120 are turned or rotated only slightly in the clockwise direction, the resistance of the rotary potentiometer 118 is at its greatest and the triac turns on rather slowly and is rendered non-conductive for a longer period of time than when the wiper component and the keyed shaft 120 are turned or rotated more in the clockwise direction.

In this manner, rotating the button top 138 of the rotary switch 100 rotates the button chassis 124 which then rotates the keyed shaft 120 and, ultimately, the wiper component within the rotary potentiometer 118 which determines the resistance of the rotary potentiometer 118. The resistance of the rotary potentiometer 118 along with the conductive state of the triac then play a part in controlling the brightness or intensity of the lighting load 202 when the rotary switch 100 is electrically coupled to a power source (e.g., the wall receptacle 212) and the lighting load 202.

In some embodiments, the rotary potentiometer 118 can be a potentiometer normally used for audio applications. For example, the rotary potentiometer 118 can be a potentiometer developed or distributed by Taiwan Alpha Electronic Co., Ltd.

Moreover, the rotary potentiometer 118 can have a total rotation angle of about 260° ± 5°. The rotary potentiometer 118 can have a maximum operating voltage of 200V. The resistance of the rotary potentiometer 118 can change in a linear manner or have a linear taper. Moreover, the resistance of the rotary potentiometer 118 can range from 1 kΩ to 1 MΩ.

Fig. 4B also illustrates that the keyed shaft 120 can have two longer parallel sides and two curved or rounded shorter sides. In some embodiments, the keyed shaft 120 can be substantially shaped as a rectangular prism. In these embodiments, the keyhole passage 126 of the button chassis 124 can be a cavity, void, or space also shaped as a rectangular prism to accommodate at least part of the keyed shaft 120 (see Fig. 1A and 3B).

In other embodiments, the keyed shaft 120 can be substantially shaped as an oval prism or a triangular prism.

As shown in Fig. 4B, the keyed shaft 120 can have a shaft length 408 and a shaft width 410. In some embodiments, the shaft length 408 can be between 3.5 mm and 4.5 mm (e.g., about 4.0 mm) and the shaft width 410 can be between 1.7 mm and 3.0 mm (e.g., about 2.4 mm). In certain embodiments, a ratio of the shaft length 408 to the shaft width 410 can be between about 2:1 to 1.5:1 (e.g., about 1.67:1).

One technical problem faced by the applicants is how to provide a wide dimming range but also provide fine-tuned control of the intensity or brightness of a lighting load. The technical solution discovered and developed by the applicants is to base the design of the rotary switch 100 around the rotary potentiometer 118 having the technical and functional parameters (e.g., the resistance range, the rotational range, etc.) disclosed herein. The rotary potentiometer 118 also allows the rotary switch 100 to be used with a variety of lights and lamps ranging from table lights/lamps to floor lights/lamps and wall lights/lamps. Moreover, the rotary potentiometer 118 also allows the rotary switch 100 to be used with different kinds of LED lighting loads. As previously discussed, one added benefit of the rotary potentiometer 118 disclosed herein is that the rotary potentiometer 118 can be mounted to the PCB 112 in such a way that minimizes the maximum switch height 166 (see, e.g., Fig. 1B).

Fig. 4C illustrates a side view of the rotary potentiometer 118 mounted on the PCB 112. As shown in Fig. 4C, the rotary potentiometer 118 can be mounted within the cutout 400 of the PCB 112 (see Fig. 4A) such that at least an upper portion 412 of the rotary potentiometer 118 is positioned above a top surface 414 of the PCB 112 and a lower portion 416 of the rotary potentiometer 118 is positioned below a bottom surface 418 of the PCB 112.

The manner in which the rotary potentiometer 118 is mounted to the PCB 112 (see, e.g., Fig. 4C) is an advancement in the field of physical rotary switches as the rotary potentiometer in such switches is often the largest electronic component that takes up the most room. Thus, one technical problem faced by the applicants is how to mount the rotary potentiometer 118 to the PCB 112 such that the entire PCB-potentiometer assemblage can fit within the limited space within the assembled switch enclosure 164 (see, e.g., Fig. 1B). The technical solution discovered and developed by the applicants is to mount the low-profile rotary potentiometer 118 shown in Fig. 4B in the cutout 400 defined along the edge 402 of the PCB 112. The rotary potentiometer 118 is mounted such that the upper portion 412 of the rotary potentiometer 118 is positioned above the top surface 414 of the PCB 112 and the lower portion 416 of the rotary potentiometer 118 is positioned below the bottom surface 418 of the PCB 112.

Fig. 4C also illustrates that the rotary potentiometer 118 can have a potentiometer maximum height 420. The potentiometer maximum height 420 can be between about 9.00 mm and 9.50 mm (e.g., about 9.10 mm). By being mounted partly through the PCB 112, the potentiometer maximum height 420 (e.g., the ~9 mm height of the rotary potentiometer 118) is distributed somewhat evenly between the top and bottom of the PCB 112. This is a significant improvement over traditional rotary switches where the normally bulky rotary potentiometer of such switches (which can have a height of more than 20.00 mm) are surface mounted to a PCB of the switch such that the entire rotary potentiometer sits on top of the PCB and requires a bulky switch housing and equally bulky switch button to contain the potentiometer and PCB.

Fig. 5A illustrates a perspective view of the underside 501 of the top switch enclosure 102 of the rotary switch 100. As previously discussed, the top switch enclosure 102 can comprise an opening 106 defined along the top switch enclosure 102.

The top switch enclosure 102 can have a proximal longitudinal end 500 and a distal longitudinal end 502 opposite the proximal longitudinal end 500. The opening 106 can be positioned closer to the proximal longitudinal end 500 than the distal longitudinal end 502. The top switch enclosure 102 can further comprise a pair of proximal securement posts 504 positioned closer to the proximal longitudinal end 500 than the distal longitudinal end 502.

Each of the proximal securement posts 504 can comprise serrated protrusions 506 extending from a lateral side of each of the proximal securement posts 504. For example, each of the proximal securement posts 504 can comprise serrated protrusions 506 extending from the lateral side of each of the proximal securement posts 504 closest to a curved proximal corner 508A of the underside 501 of the top switch enclosure 102.

The top switch enclosure 102 can further comprise a pair of distal securement posts 510 positioned closer to the distal longitudinal end 502 of the top switch enclosure 102 than the proximal longitudinal end 500. Each of the distal securement posts 510 can comprise serrated protrusions 506 extending from a lateral side of each of the distal securement posts 510. For example, each of the distal securement posts 510 can comprise serrated protrusions 506 extending from the lateral side of each of the distal securement posts 510 closest to a curved distal corner 508B of the underside 501 of the top switch enclosure 102.

The proximal securement posts 504 and the distal securement posts 510 can project downward (vertically downward) from the underside 501 of the top switch enclosure 102.

As previously discussed, the top switch enclosure 102 and the bottom switch enclosure 104 of the power cord and rotary switch assembly 204 can be coupled together to form an assembled switch enclosure 164 (see, e.g., Fig. 1B). The assembled switch enclosure 164 can comprise an input port 176 and an output port 178 (see also, e.g., Fig. 1A) positioned on opposite longitudinal ends of the assembled switch enclosure 164. For example, the input port 176 can be defined or otherwise located at the distal longitudinal end 502 and the output port 178 can be defined or otherwise located at the proximal longitudinal end 500. The input port 176 can be made up of partial port openings (e.g., substantially semicircular-shaped openings) defined at the distal longitudinal end 502 of the top switch enclosure 102 and the distal longitudinal end 502 of the bottom switch enclosure 104. The output port 178 can be made up of partial port openings (e.g., substantially semicircular-shaped openings) defined at the proximal longitudinal end 500 of the top switch enclosure 102 and the proximal longitudinal end 500 of the bottom switch enclosure 104.

At least a segment of the input cord 114 can extend into the enclosure cavity 110 through the input port 176. At least a segment of the output cord 116 can extend into the enclosure cavity 110 through the output port 178.

The top switch enclosure 102 can also comprise one or more distal top toothed arches 512 and one or more proximal top toothed arches 514 extending downward from the underside 501 of the top switch enclosure. In some embodiments, the top switch enclosure 102 can comprise two distal top toothed arches 512 positioned longitudinally in series with one another. The one or more distal top toothed arches 512 can be positioned or defined proximal to the input port 176. For example, a first instance of one of the distal top toothed arches 512 can be positioned or defined immediately proximal to the input port 176 and a second instance of one of the distal top toothed arches 512 can be positioned or defined proximal to the first instance of the distal top toothed arch 512. In these and other embodiments, the top switch enclosure 102 can comprise two proximal top toothed arches 514 positioned longitudinally in series with one another. The one or more proximal top toothed arches 514 can be positioned or defined distal to the output port 178. For example, a first instance of one of the proximal top toothed arches 514 can be positioned or defined immediately distal to the output port 178 and a second instance of one of the proximal top toothed arches 514 can be positioned or defined distal to the first instance of the proximal top toothed arch 514.

As shown in Fig. 1A, the bottom switch enclosure 104 can comprise one or more distal bottom toothed arches 180 and one or more proximal bottom toothed arches 182 extending upward from the bottom switch enclosure 104. In some embodiments, the bottom switch enclosure 104 can comprise two distal bottom toothed arches 180 positioned longitudinally in series with one another. The one or more distal bottom toothed arches 180 can be positioned or defined proximal to the input port 176. For example, a first instance of one of the distal bottom toothed arches 180 can be positioned or defined immediately proximal to the input port 176 and a second instance of one of the distal bottom toothed arches 180 can be positioned or defined proximal to the first instance of the distal bottom toothed arch 180. In these and other embodiments, the bottom switch enclosure 104 can comprise two proximal bottom toothed arches 182 positioned longitudinally in series with one another. The one or more proximal bottom toothed arches 182 can be positioned or defined distal to the output port 178. For example, a first instance of one of the proximal bottom toothed arches 182 can be positioned or defined immediately distal to the output port 178 and a second instance of one of the proximal bottom toothed arches 182 can be positioned or defined distal to the first instance of the proximal bottom toothed arch 182.

The one or more distal top toothed arches 512 and the one or more distal bottom toothed arches 180 can work together to clamp or secure the segment of the input cord 114 within the enclosure cavity 110. For example, the one or more distal top toothed arches 512 and the one or more distal bottom toothed arches 180 can work together to clamp an insulating layer or insulator of the input cord 114.

The one or more proximal top toothed arches 514 and the one or more proximal bottom toothed arches 182 can work together to clamp or secure the segment of the output cord 116 within the enclosure cavity 110. For example, the one or more proximal top toothed arches 514 and the one or more proximal bottom toothed arches 182 can work together to clamp an insulating layer or insulator of the output cord 116.

Fig. 5B illustrates one embodiment of part of the power cord and rotary switch assembly 204 with certain electronic and electrical components of the rotary switch 100 secured to the top switch enclosure 102 (which is flipped upside down in this figure) and the bottom switch enclosure 104 of the rotary switch 100 separated from the top switch enclosure 102 for ease of viewing.

Fig. 5B illustrates that at least a segment of the input cord 114 can extend into the enclosure cavity 110 through the input port 176 at the distal longitudinal end 502. Also, at least a segment of the output cord 116 can extend into the enclosure cavity 110 through the output port 178 at the proximal longitudinal end 500.

The input cord 114 can comprise an input live cable 520 having input live wires extending therethrough and an input neutral cable 522 having input neutral wires extending therethrough. The segment of the input cord 114 within the enclosure cavity 110 can separate into the input live cable 520 and the input neutral cable 522 within the enclosure cavity 110. For example, the segment of the input cord 114 within the enclosure cavity 110 proximal of the input port 176 can separate into the input live cable 520 and the input neutral cable 522 within the enclosure cavity 110. More specifically, for example, the segment of the input cord 114 within the enclosure cavity 110 proximal of the one or more distal top toothed arches 512 and proximal of the one or more distal bottom toothed arches 180 can separate into the input live cable 520 and the input neutral cable 522 within the enclosure cavity 110.

The input live wires of the input live cable 520 and the input neutral wires of the input neutral cable 522 can be electrically coupled or connected (e.g., soldered or otherwise conductively coupled) to the PCB 112 of the rotary switch 100. For example, the PCB 112 can comprise a live input terminal for connecting or coupling to the input live wires and a neutral input terminal for connecting or coupling to the input neutral wires.

The output cord 116 can comprise an output live cable 516 having output live wires extending therethrough and an output neutral cable 518 having output neutral wires extending therethrough. The segment of the output cord 116 within the enclosure cavity 110 can separate into the output live cable 516 and the output neutral cable 518 within the enclosure cavity 110. For example, the segment of the output cord 116 within the enclosure cavity 110 proximal of the output port 178 can separate into the output live cable 516 and the output neutral cable 518 within the enclosure cavity 110. More specifically, for example, the segment of the output cord 116 within the enclosure cavity 110 distal of the one or more proximal top toothed arches 514 and distal of the one or more proximal bottom toothed arches 182 can separate into the output live cable 516 and the output neutral cable 518 within the enclosure cavity 110.

The output wires of the output live cable 516 and the output neutral wires of the output neutral cable 518 can be electrically coupled or connected (e.g., soldered or otherwise conductively coupled) to the PCB 112 of the rotary switch 100. For example, the PCB 112 can comprise a live output terminal for connecting or coupling to the output live wires and a neutral output terminal for connecting or coupling to the output neutral wires.

Each of the input live cable 520 and the input neutral cable 522 can be secured in part within the enclosure cavity 110 by an interference fit between an interior wall segment 524 (e.g., part of the curved distal corner 508B) on the underside 501 of the top switch enclosure 102 and one of the distal securement posts 510.

In some embodiments, the segment of the input live cable 520 within the enclosure cavity 110 can be bent into an L-shaped segment 526. The part of the input live cable 520 bent into the L-shaped segment 526 can be secured in part within the enclosure cavity 110 by an interference fit between the interior wall segment 524 of the underside 501 of the top switch enclosure 102 and one of the distal securement posts 510. More specifically, the part of the input live cable 520 bent into the L-shaped segment 526 can be secured in part within the enclosure cavity 110 by an interference fit between the interior wall segment 524 of the underside 501 of the top switch enclosure 102 and the serrated protrusions 506 of one of the distal securement posts 510.

In these and other embodiments, the segment of the input neutral cable 522 within the enclosure cavity 110 can be bent into an L-shaped segment 526. The part of the input neutral cable 522 bent into the L-shaped segment 526 can be secured in part within the enclosure cavity 110 by an interference fit between the interior wall segment 524 of the underside 501 of the top switch enclosure 102 and another one of the distal securement posts 510. More specifically, the part of the input neutral cable 522 bent into the L-shaped segment 526 can be secured in part within the enclosure cavity 110 by an interference fit between the interior wall segment 524 of the underside 501 of the top switch enclosure 102 and the serrated protrusions 506 of another one of the distal securement posts 510.

Each of the output live cable 516 and the output neutral cable 518 can be secured in part within the enclosure cavity 110 by an interference fit between an interior wall segment 524 (e.g., part of the curved proximal corner 508A) on the underside 501 of the top switch enclosure 102 and one of the proximal securement posts 504.

In some embodiments, the segment of the output live cable 516 within the enclosure cavity 110 can be bent into an L-shaped segment 526. The part of the output live cable 516 bent into the L-shaped segment 526 can be secured in part within the enclosure cavity 110 by an interference fit between the interior wall segment 524 of the underside 501 of the top switch enclosure 102 and one of the proximal securement posts 504. More specifically, the part of the output live cable 516 bent into the L-shaped segment 526 can be secured in part within the enclosure cavity 110 by an interference fit between the interior wall segment 524 of the underside 501 of the top switch enclosure 102 and the serrated protrusions 506 of one of the proximal securement posts 504.

In these and other embodiments, the segment of the output neutral cable 518 within the enclosure cavity 110 can be bent into an L-shaped segment 526. The part of the output neutral cable 518 bent into the L-shaped segment 526 can be secured in part within the enclosure cavity 110 by an interference fit between the interior wall segment 524 of the underside 501 of the top switch enclosure 102 and another one of the proximal securement posts 504. More specifically, the part of the output neutral cable 518 bent into the L-shaped segment 526 can be secured in part within the enclosure cavity 110 by an interference fit between the interior wall segment 524 of the underside 501 of the top switch enclosure 102 and the serrated protrusions 506 of another one of the proximal securement posts 504.

In certain embodiments, part of the L-shaped segment 526 of one of the input live cable 520 or the input neutral cable 522 can be secured to the top switch enclosure 102 by being pressed into a distal securement space 530 in between the interior wall segment 524 on the underside 501 of the top switch enclosure 102 and one of the distal securement posts 510 (e.g., the serrated protrusions 506 of one of the distal securement posts 510). In these and other embodiments, part of the L-shaped segment 526 of one of the output live cable 516 or the output neutral cable 518 can be secured to the top switch enclosure 102 by being pressed into a proximal securement space 528 in between the other interior wall segment 524 on the underside 501 of the top switch enclosure 102 and one of the proximal securement posts 504 (e.g., the serrated protrusions 506 of one of the proximal securement posts 504).

The proximal securement space 528 can have a proximal space width 532. The proximal space width 532 can be between about 4.00 mm and 5.00 mm (e.g., about 4.67 mm). The distal securement space 530 can have a distal space width 534. The distal space width 534 can be between about 4.00 mm and 5.00 mm (e.g., about 4.67 mm).

Since the input live wires of the input live cable 520 and the input neutral wires of the input neutral cable 522 are electrically coupled or connected (e.g., soldered or otherwise conductively coupled) to the PCB 112 of the rotary switch 100 and the output wires of the output live cable 516 and the output neutral wires of the output neutral cable 518 are electrically coupled or connected (e.g., soldered or otherwise conductively coupled) to the PCB 112 of the rotary switch 100, the PCB 112 can be secured within the enclosure cavity 110 when some combination of the input live cable 520, the input neutral cable 522, the output live cable 516, and the output neutral cable 518 are at least secured to the top switch enclosure 102.

Moreover, the proximal securement posts 504 and the distal securement posts 510 can also function as fastener receptacles for fasteners 536 configured to fasten or couple the bottom switch enclosure 104 to the top switch enclosure 102.

As shown in Fig. 5B, a plurality of apertures 538 or threaded through-holes can be defined along a bottom side 540 of the bottom switch enclosure 104. The fasteners 536 can extend through the apertures 538 or threaded through-holes and into hollow channels or elongate cavities of the proximal securement posts 504 and into hollow channels or elongate cavities of the distal securement posts 510. In this manner, the plurality of proximal securement posts 504 and distal securement posts 510 can serve two purposes and space is ultimately conserved within the assembled switch enclosure 164 due to this advantageous design.

As previously discussed, the rotary switch 100 can also comprise an anti-slip pad 162 or anti-slip layer (see, e.g., Fig. 1A) affixed or otherwise coupled to the bottom side 540 of the bottom switch enclosure 104. In some embodiments, the bottom side 540 of the bottom switch enclosure 104 can comprise a depression 542 or be set in from an outer edge 544 of the bottom switch enclosure 104. This can allow the anti-slip pad 162 or anti-slip layer to be affixed or otherwise coupled (e.g., via adhesives) to the depression 542 but still be flush with the outer edge 544 of the bottom side 540 of the bottom switch enclosure 104.

One technical product faced by the applicants is how to design a power cord and rotary switch assembly 204 such that the size of the rotary switch 100 is minimized and aesthetically pleasing but that the assembly itself passes all required product safety strain relief tests. For example, such tests verify that normal stresses or forces applied to such assemblies (e.g., caused by a user tripping over a cord, pulling on the cord, carrying the assembly by its cord, or trying unplug a cord, etc.) does not result in an electrical connection or cable becoming detached leading to a fault condition that results in electrical shock or a fire hazard. Such strain relief tests often involve at least pull force tests, push-back tests, and rotational torque tests. The technical solution discovered and developed by the applicants is to design the power cord and rotary switch assembly 204 in the manner disclosed herein such that the segments of the input cord 114 and output cord 116 extending into the assembled switch enclosure 164 are secured by both the top switch enclosure 102 and the bottom switch enclosure 104. Moreover, as disclosed herein, the output (line) live/hot cable 516 and the output (line) neutral cable 518 and the input (load) live/hot cable 520 and the input (load) neutral cable 522 within the enclosure cavity 110 are secured by the way such cables are positioned and bent around securement posts (including around the serrated protrusions 506 of such securement posts) positioned near the edges and corners of the top switch enclosure 102. The applicants discovered that this design not only allows the power cord and rotary switch assembly 204 to pass all required strain relief tests but also does not unnecessarily increase the overall footprint or size of the assembled rotary switch 100.

A number of embodiments have been described. Nevertheless, it will be understood by one of ordinary skill in the art that various changes and modifications can be made to this disclosure without departing from the scope of the invention as defined by the appended claims. Elements of systems, devices, apparatus, and methods shown with any embodiment are exemplary for the specific embodiment and can be used in combination or otherwise on other embodiments within this disclosure. For example, the steps of any methods depicted in the figures or described in this disclosure do not require the particular order or sequential order shown or described to achieve the desired results. In addition, other steps operations may be provided, or steps or operations may be eliminated or omitted from the described methods or processes to achieve the desired results. Moreover, any components or parts of any apparatus or systems described in this disclosure or depicted in the figures may be removed, eliminated, or omitted to achieve the desired results. In addition, certain components or parts of the systems, devices, or apparatus shown or described herein have been omitted for the sake of succinctness and clarity.

Accordingly, other embodiments are within the scope of the following claims and the specification and/or drawings may be regarded in an illustrative rather than a restrictive sense.

Each of the individual variations or embodiments described and illustrated herein has discrete components and features which may be readily separated from or combined with the features of any of the other variations or embodiments. Modifications may be made to adapt a particular situation, material, composition of matter, process, process act(s) or step(s) to the objective(s).

Methods recited herein may be carried out in any order of the recited events that is logically possible, as well as the recited order of events. Moreover, additional steps or operations may be provided or steps or operations may be eliminated to achieve the desired result.

Furthermore, where a range of values is provided, every intervening value between the upper and lower limit of that range and any other stated or intervening value in that stated range is encompassed within the invention. Also, any optional feature of the inventive variations described may be set forth and claimed independently, or in combination with any one or more of the features described herein. For example, a description of a range from 1 to 5 should be considered to have disclosed subranges such as from 1 to 3, from 1 to 4, from 2 to 4, from 2 to 5, from 3 to 5, etc. as well as individual numbers within that range, for example 1.5, 2.5, etc. and any whole or partial increments therebetween.

Reference to a singular item, includes the possibility that there are plural of the same items present. More specifically, as used herein and in the appended claims, the singular forms "a," "an," "said" and "the" include plural referents unless the context clearly dictates otherwise. It is further noted that the claims may be drafted to exclude any optional element. As such, this statement is intended to serve as antecedent basis for use of such exclusive terminology as "solely," "only" and the like in connection with the recitation of claim elements, or use of a "negative" limitation. Unless defined otherwise, all technical and scientific terms used herein have the same meaning as commonly understood by one of ordinary skill in the art to which this invention belongs.

Reference to the phrase "at least one of", when such phrase modifies a plurality of items or components (or an enumerated list of items or components) means any combination of one or more of those items or components. For example, the phrase "at least one of A, B, and C" means: (i) A; (ii) B; (iii) C; (iv) A, B, and C; (v) A and B; (vi) B and C; or (vii) A and C.

In understanding the scope of the present disclosure, the term "comprising" and its derivatives, as used herein, are intended to be open-ended terms that specify the presence of the stated features, elements, components, groups, integers, and/or steps, but do not exclude the presence of other unstated features, elements, components, groups, integers and/or steps. The foregoing also applies to words having similar meanings such as the terms, "including", "having" and their derivatives. Also, the terms "part," "section," "portion," "member" "element," or "component" when used in the singular can have the dual meaning of a single part or a plurality of parts. As used herein, the following directional terms "forward, rearward, above, downward, vertical, horizontal, below, transverse, laterally, and vertically" as well as any other similar directional terms refer to those positions of a device or piece of equipment or those directions of the device or piece of equipment being translated or moved.

Finally, terms of degree such as "substantially", "about" and "approximately" as used herein mean the specified value or the specified value and a reasonable amount of deviation from the specified value (e.g., a deviation of up to ±0.1%, ±1%, ±5%, or ±10%, as such variations are appropriate) such that the end result is not significantly or materially changed. For example, "about 1.0 cm" can be interpreted to mean "1.0 cm" or between "0.9 cm and 1.1 cm." When terms of degree such as "about" or "approximately" are used to refer to numbers or values that are part of a range, the term can be used to modify both the minimum and maximum numbers or values.

## Claims

1. A rotary switch (100) for controlling a brightness or intensity of a lighting load, comprising:
a top switch enclosure (102) comprising an opening (106) defined along a top surface (108) of the top switch enclosure (102);
a bottom switch enclosure (104) coupled to the top switch enclosure (102), wherein the top switch enclosure (102) and the bottom switch enclosure (104) form an enclosure cavity (110) when coupled;
a printed circuit board (PCB) (112) housed within the enclosure cavity (110);
a rotary potentiometer (118) mounted to the PCB (112) and comprising a keyed shaft (120) protruding through the opening (106) of the top switch enclosure (102) when the PCB (112) is housed within the enclosure cavity (110), wherein the keyed shaft (120) comprises a threaded receptacle (122) extending partially into the keyed shaft (120),
wherein rotation of the keyed shaft (120) varies a resistance of the rotary potentiometer (118); **characterised by**:
a button chassis (124) comprising a keyhole passage (126) defined therethrough, wherein the button chassis (124) is coupled to the keyed shaft (120) by a fastener (128) partly screwed into the threaded receptacle (122) and wherein at least part of the keyed shaft (120) protrudes into the keyhole passage (126) when the button chassis (124) is coupled to the keyed shaft (120) by the fastener (128); and
a button top (138) configured to fit over and partially encapsulate the button chassis (124), wherein the button top (138) is configured to be non-detachably coupled to the button chassis (124) when the button top (138) is pressed onto the button chassis (124), and wherein rotating the button top (138) rotates the button chassis (124) and keyed shaft (120) such that the brightness or intensity of a lighting load (202) is controllable via rotation of the button top (138).

2. The rotary switch of claim 1, wherein the button chassis comprises a chassis body portion, wherein the chassis body portion is substantially shaped as a flattened cylindrical cap, wherein the chassis body portion comprises chassis base and chassis lateral walls extending from the chassis base, wherein the chassis body portion further comprises a plurality of angled chassis projections protruding radially outward from an exterior surface of the chassis lateral walls, wherein the button top comprises a button top lateral wall, wherein the button top further comprises a plurality of angled ledge projections protruding radially inward from an interior surface of the button top lateral wall, and wherein the plurality of angled chassis projections of the button chassis interlock with the angled ledge projections of the button top to non-detachably couple the button top to the button chassis when the button top is pressed onto the button chassis.

3. The rotary switch of claim 2, wherein the button chassis further comprises a plurality of slits oriented radially around a central portion of the chassis body portion such that a radially-outer portion of the chassis body portion is divided into a plurality of petal-like sections, wherein each of the petal-like sections of the chassis body portion comprises one angled chassis projection.

4. The rotary switch of claim 2 or 3, wherein each of the angled chassis projections comprises a chassis projection base and a chassis projection sloped surface, wherein each of the angled ledge projections comprises a ledge top surface and a ledge projection sloped surface, wherein the ledge projection sloped surfaces of the angled ledge projections are configured to slide against the chassis projection sloped surfaces to allow the button top to be pressed onto the button chassis, and wherein the chassis projection base and the chassis lateral wall form an undercut for accepting the angled ledge projection and interlocking with the angled ledge projection once the ledge top surface is pressed below the chassis projection base.

5. The rotary switch of any one of claims 1 to 4, wherein the button chassis comprises a chassis body portion comprising a plurality of slits oriented radially around a central portion of the chassis body portion, wherein the button top comprises a plurality of gusset supports oriented radially on an underside of the button top, wherein the gusset supports are positioned within the slits when the button top is coupled to the button chassis, and wherein the gusset supports are designed to translate a rotational force applied to the button top to the button chassis to rotate the button chassis.

6. The rotary switch of any one of claims 1 to 5, wherein the fastener comprises a fastener head, wherein the keyed shaft comprises a shaft head, and wherein the rotary switch further comprises a washer disposed in between the fastener head and the shaft head when the fastener is partly screwed into the threaded receptacle of the keyed shaft.

7. The rotary switch of any one of claims 1 to 6, wherein the rotary switch has a maximum switch height as measured from a top-most surface of the button top to a bottom-most surface of the bottom switch enclosure, wherein the maximum switch height is between about 20.00 mm and about 22.00 mm.

8. The rotary switch of any one of claims 1 to 7, wherein the bottom switch enclosure is coupled to the top switch enclosure to form an assembled switch enclosure, wherein the assembled switch enclosure has a maximum enclosure height as measured from the top surface of the top switch enclosure to a bottom-most surface of the bottom switch enclosure, wherein the maximum enclosure height is between about 12.00 mm and about 14.00 mm.

9. The rotary switch of claim 8, wherein the rotary switch has a maximum switch width and a maximum switch length, wherein the maximum switch width is a maximum width of the assembled switch enclosure, wherein the maximum switch width is between about 37.00 mm and about 40.00 mm, wherein the maximum switch length is a maximum length of the assembled switch enclosure, wherein the maximum switch length is between about 61.00 mm to 65.00 mm.

10. The rotary switch of any one of claims 1 to 9, wherein the PCB comprises a cutout defined along an edge of the PCB, wherein the rotary potentiometer is mounted within the cutout such that at least an upper portion of the rotary potentiometer is positioned above a top surface of the PCB and a lower portion of the rotary potentiometer is positioned below a bottom surface of the PCB.

11. The rotary switch of any one of claims 1 to 10, wherein the keyed shaft is coupled to a wiper component of the rotary potentiometer, wherein the wiper component is electrically coupled to a variable terminal of the rotary potentiometer, wherein the wiper component rotates in response to a rotation of the keyed shaft, and wherein a resistance of the rotary potentiometer varies in response to a rotation of the wiper component.

## Patentansprüche

1. Drehschalter (100) zum Steuern einer Helligkeit oder Intensität einer Beleuchtungslast, umfassend:
ein oberes Schaltergehäuse (102), das eine Öffnung (106) umfasst, die entlang einer oberen Fläche (108) des oberen Schaltergehäuses (102) definiert ist;
ein unteres Schaltergehäuse (104), das mit dem oberen Schaltergehäuse (102) gekoppelt ist, wobei das obere Schaltergehäuse (102) und das untere Schaltergehäuse (104) einen Gehäusehohlraum (110) bilden, wenn sie gekoppelt sind;
eine gedruckte Schaltkarte (Printed Circuit Board, PCB) (112), die in dem Gehäusehohlraum (110) untergebracht ist;
ein Drehpotentiometer (118), das an der PCB (112) angebracht ist und eine Keilwelle (120) umfasst, die durch die Öffnung (106) des oberen Schaltergehäuses (102) ragt, wenn die PCB (112) in dem Gehäusehohlraum (110) untergebracht ist, wobei die Keilwelle (120) eine Gewindeaufnahme (122) umfasst, die sich teilweise in die Keilwelle (120) erstreckt, wobei die Drehung der Keilwelle (120) einen Widerstand des Drehpotentiometers (118) variiert;
**gekennzeichnet durch**:
ein Tastenchassis (124), das einen durch dieses hindurch definierten Schlüssellochdurchgang (126) umfasst, wobei das Tastenchassis (124) mit der Keilwelle (120) durch ein Befestigungselement (128) gekoppelt ist, das teilweise in die Gewindeaufnahme (122) geschraubt ist, und wobei mindestens ein Teil der Keilwelle (120) in den Schlüssellochdurchgang (126) hineinragt, wenn das Tastenchassis (124) durch das Befestigungsmittel (128) mit der Keilwelle (120) gekoppelt ist; und
eine Tastenoberseite (138), die so konfiguriert ist, dass sie über das Tastenchassis (124) passt und dieses teilweise einkapselt, wobei die Tastenoberseite (138) so konfiguriert ist, dass sie unlösbar mit dem Tastenchassis (124) gekoppelt ist, wenn die Tastenoberseite (138) auf das Tastenchassis (124) gedrückt wird, und wobei eine Drehung der Tastenoberseite (138) das Tastenchassis (124) und die Keilwelle (120) dreht, so dass die Helligkeit oder Intensität einer Beleuchtungslast (202) über eine Drehung der Tastenoberseite (138) steuerbar ist.

2. Drehschalter nach Anspruch 1, wobei das Tastenchassis einen Chassiskörperabschnitt umfasst, wobei der Chassiskörperabschnitt im Wesentlichen als abgeflachte zylindrische Kappe gebildet ist, wobei der Chassiskörperabschnitt eine Chassisbasis und Chassisseitenwände umfasst, die sich von der Chassisbasis aus erstrecken, wobei der Chassiskörperabschnitt ferner eine Vielzahl von abgewinkelten Chassisvorsprüngen umfasst, die von einer Außenfläche der Chassisseitenwände radial nach außen ragen, wobei die Tastenoberseite eine Tastenoberseitenwand umfasst, wobei die Tastenoberseite ferner eine Vielzahl von abgewinkelten Leistenvorsprüngen umfasst, die von einer Innenfläche der Tastenoberseitenwand radial nach innen ragen, und wobei die Vielzahl von abgewinkelten Gehäusevorsprüngen des Tastenchassis mit den abgewinkelten Leistenvorsprüngen der Tastenoberseite ineinandergreifen, um die Tastenoberseite nicht lösbar mit dem Tastenchassis zu koppeln, wenn die Tastenoberseite auf das Tastenchassis gedrückt wird.

3. Drehschalter nach Anspruch 2, wobei das Tastenchassis ferner eine Vielzahl von Schlitzen umfasst, die radial um einen zentralen Abschnitt des Chassiskörperabschnitts ausgerichtet sind, so dass ein radial äußerer Abschnitt des Chassiskörperabschnitts in eine Vielzahl von blütenblattartigen Abschnitten unterteilt ist, wobei jeder der blütenblattartigen Abschnitte des Chassiskörperabschnitts einen abgewinkelten Chassisvorsprung umfasst.

4. Drehschalter nach Anspruch 2 oder 3, wobei jeder der abgewinkelten Chassisvorsprünge eine Chassisvorsprungbasis und eine Chassisvorsprungschrägfläche umfasst, wobei jeder der abgewinkelten Leistenvorsprünge eine Leistenoberseite und eine Leistenvorsprungschrägfläche umfasst, wobei die Leistenvorsprungsschrägflächen der abgewinkelten Leistenvorsprünge so konfiguriert sind, dass sie gegen die Chassisvorsprungsschrägflächen gleiten, um zu ermöglichen, dass die Tastenoberseite auf das Tastenchassis gedrückt werden kann, und wobei die Chassisvorsprungbasis und die Chassisseitenwand eine Hinterschneidung zur Aufnahme des abgewinkelten Leistenvorsprungs und zur Verriegelung mit dem abgewinkelten Leistenvorsprung bilden, sobald die Oberfläche der Leistenoberseite unter die Chassisvorsprungsbasis gedrückt wird.

5. Drehschalter nach einem der Ansprüche 1 bis 4, wobei das Tastenchassis einen Chassiskörperabschnitt umfasst, der eine Vielzahl von Schlitzen umfasst, die radial um einen zentralen Abschnitt des Chassiskörperabschnitts ausgerichtet sind, wobei die Tastenoberseite eine Vielzahl von Zwickelstützen umfasst, die radial auf einer Unterseite der Tastenoberseite ausgerichtet sind, wobei die Zwickelstützen innerhalb der Schlitze positioniert sind, wenn die Tastenoberseite mit dem Tastenchassis gekoppelt ist, und wobei die Zwickelstützen so ausgelegt sind, dass sie eine auf die Tastenoberseite ausgeübte Drehkraft auf das Tastenchassis übertragen, um das Tastenchassis zu drehen.

6. Drehschalter nach einem der Ansprüche 1 bis 5, wobei das Befestigungselement einen Befestigungskopf umfasst, wobei die Keilwelle einen Wellenkopf umfasst, und wobei der Drehschalter ferner eine Unterlegscheibe umfasst, die zwischen dem Befestigungskopf und dem Wellenkopf angeordnet ist, wenn das Befestigungselement teilweise in die Gewindeaufnahme des Keilwelle eingeschraubt ist.

7. Drehschalter nach einem der Ansprüche 1 bis 6, wobei der Drehschalter eine maximale Schalterhöhe aufweist, gemessen von einer obersten Fläche der Tastenoberseite zu einer untersten Fläche des unteren Schaltergehäuses, wobei die maximale Schalterhöhe zwischen etwa 20,00 mm und etwa 22,00 mm liegt.

8. Drehschalter nach einem der Ansprüche 1 bis 7, wobei das untere Schaltergehäuse mit dem oberen Schaltergehäuse gekoppelt ist, um ein zusammengesetztes Schaltergehäuse zu bilden, wobei das zusammengesetzte Schaltergehäuse eine maximale Gehäusehöhe aufweist, gemessen von der oberen Fläche des oberen Schaltergehäuses zu einer untersten Fläche des unteren Schaltergehäuses, wobei die maximale Schalterhöhe zwischen etwa 12,00 mm und etwa 14,00 mm liegt.

9. Drehschalter nach Anspruch 8, wobei der Drehschalter eine maximale Schalterbreite und eine maximale Schalterlänge aufweist, wobei die maximale Schalterbreite eine maximale Breite des zusammengesetzten Schaltergehäuses ist, wobei die maximale Schalterbreite zwischen etwa 37,00 mm und etwa 40,00 mm liegt, wobei die maximale Schalterlänge eine maximale Länge des zusammengesetzten Schaltergehäuses ist, wobei die maximale Schalterlänge zwischen etwa 61,00 mm bis 65,00 mm liegt.

10. Drehschalter nach einem der Ansprüche 1 bis 9, wobei die PCB einen Ausschnitt umfasst, der entlang einer Kante der PCB definiert ist, wobei das Drehpotentiometer innerhalb des Ausschnitts so angebracht ist, dass mindestens ein oberer Teil des Drehpotentiometers über einer oberen Oberfläche der PCB und ein unterer Teil des Drehpotentiometers unter einer unteren Oberfläche der PCB angeordnet ist.

11. Drehschalter nach einem der Ansprüche 1 bis 10, wobei die Keilwelle mit einer Schleiferkomponente des Drehpotentiometers gekoppelt ist, wobei die Schleiferkomponente elektrisch mit einem variablen Anschluss des Drehpotentiometers gekoppelt ist, wobei sich die Schleiferkomponente als Reaktion auf eine Drehung der Keilwelle dreht, und wobei sich ein Widerstand des Drehpotentiometers in Abhängigkeit von einer Drehung der Schleiferkomponente ändert.

## Revendications

1. Interrupteur rotatif (100) pour commander une luminosité ou intensité d'une charge d'éclairage, comprenant :
une enceinte d'interrupteur de dessus (102) comprenant une ouverture (106) définie le long d'une surface de dessus (108) de l'enceinte d'interrupteur de dessus (102) ;
une enceinte d'interrupteur de dessous (104) couplée à l'enceinte d'interrupteur de dessus (102), dans lequel l'enceinte d'interrupteur de dessus (102) et l'enceinte d'interrupteur de dessous (104) forment une cavité d'enceinte (110) lorsqu'elles sont couplées ;
une carte de circuit imprimé (« Printed Circuit Board », PCB) (112) logée à l'intérieur de la cavité d'enceinte (110) ;
un potentiomètre rotatif (118) monté sur la PCB (112) et comprenant un arbre claveté (120) faisant saillie à travers l'ouverture (106) ou l'enceinte d'interrupteur de dessus (102) lorsque la PCB (112) est logée à l'intérieur de la cavité d'enceinte (110), dans lequel l'arbre claveté (120) comprend un réceptacle fileté (122) s'étendant partiellement dans l'arbre claveté (120), dans lequel la rotation de l'arbre claveté (120) fait varier une résistance du potentiomètre rotatif (118) ; **caractérisé par** :
un châssis de bouton (124) comprenant un passage en trou de serrure (126) défini à travers celui-ci, dans lequel le châssis de bouton (124) est couplé à l'arbre claveté (120) par une pièce de fixation (128) partiellement vissée dans le réceptacle fileté (122), et dans lequel au moins une partie de l'arbre claveté (120) fait saillie dans le passage en trou de serrure (126) lorsque le châssis de bouton (124) est couplé à l'arbre claveté (120) par la pièce de fixation (128) ; et
un dessus de bouton (138) configuré pour s'ajuster par-dessus et encapsuler partiellement le châssis de bouton (124), dans lequel le dessus de bouton (138) est configuré pour être couplé de façon non amovible au châssis de bouton (124) lorsque le dessus de bouton (138) est pressé sur le châssis de bouton (124), et dans lequel la rotation du dessus de bouton (138) met en rotation le châssis de bouton (124) et l'arbre claveté (120) de manière telle que la luminosité ou l'intensité d'une charge d'éclairage (202) est commandable par l'intermédiaire de la rotation du dessus de bouton (138).

2. Interrupteur rotatif de la revendication 1, dans lequel le châssis de bouton comprend une portion de corps de châssis, dans lequel la portion de corps de châssis est sensiblement façonnée sous forme de coiffe cylindrique aplatie, dans lequel la portion de corps de châssis comprend une base de châssis et des parois latérales de châssis s'étendant depuis la base de châssis, dans lequel la portion de corps de châssis comprend en outre une pluralité de saillies de châssis inclinées faisant saillie radialement vers l'extérieur à partir d'une surface extérieure des parois latérales de châssis, dans lequel le dessus de bouton comprend une paroi latérale de dessus de bouton, dans lequel le dessus de bouton comprend en outre une pluralité de saillies de rebord inclinées faisant saillie radialement vers l'intérieur à partir d'une surface intérieure de la paroi latérale de dessus de bouton, et dans lequel la pluralité de saillies de châssis inclinées du châssis de bouton s'enclenchent avec les saillies de rebord inclinées du dessus de bouton pour coupler de façon non amovible le dessus de bouton au châssis de bouton lorsque le dessus de bouton est pressé sur le châssis de bouton.

3. Interrupteur rotatif de la revendication 2, dans lequel le châssis de bouton comprend en outre une pluralité de fentes orientées radialement autour d'une portion centrale de la portion de corps de châssis de manière telle qu'une portion radialement extérieure de la portion de corps de châssis est divisée en une pluralité de sections de type pétale, dans lequel chacune des sections de type pétale de la portion de corps de châssis comprend une saillie de châssis inclinée.

4. Interrupteur rotatif de la revendication 2 ou 3, dans lequel chacune des saillies de châssis inclinées comprend une base de saillie de châssis et une surface en pente de saillie de châssis, dans lequel chacune des saillies de rebord inclinées comprend une surface de dessus de rebord et une surface en pente de saillie de rebord, dans lequel les surfaces en pente de saillie de rebord des saillies de rebord inclinées sont configurées pour coulisser contre les surfaces en pente de saillie de châssis pour permettre au dessus de bouton d'être pressé sur le châssis de bouton, et dans lequel la base de saillie de châssis et la paroi latérale de châssis forment un dégagement pour accepter la saillie de rebord inclinée et s'enclencher avec la saillie de rebord inclinée une fois que la surface de dessus de rebord est pressée en dessous de la base de saillie de châssis.

5. Interrupteur rotatif de l'une quelconque des revendications 1 à 4, dans lequel le châssis de bouton comprend une portion de corps de châssis comprenant une pluralité de fentes orientées radialement autour d'une portion centrale de la portion de corps de châssis, dans lequel le dessus de bouton comprend une pluralité de supports-goussets orientés radialement sur une sous-face du dessus de bouton, dans lequel les supports-goussets sont positionnés à l'intérieur des fentes lorsque le dessus de bouton est couplé au châssis de bouton, et dans lequel les supports-goussets sont conçus pour translater une force de rotation, appliquée sur le dessus de bouton, jusqu'au châssis de bouton pour mettre en rotation le châssis de bouton.

6. Interrupteur rotatif de l'une quelconque des revendications 1 à 5, dans lequel la pièce de fixation comprend une tête de pièce de fixation, dans lequel l'arbre claveté comprend une tête d'arbre, et dans lequel l'interrupteur rotatif comprend en outre une rondelle disposée entre la tête de pièce de fixation et la tête d'arbre lorsque la pièce de fixation est partiellement vissée dans le réceptacle fileté de l'arbre claveté.

7. Interrupteur rotatif de l'une quelconque des revendications 1 à 6, dans lequel l'interrupteur rotatif a une hauteur d'interrupteur maximum telle que mesurée depuis une surface la plus haute du dessus de bouton jusqu'à une surface la plus basse de l'enceinte d'interrupteur de dessous, dans lequel la hauteur d'interrupteur maximum est entre environ 20,00 mm et environ 22,00 mm.

8. Interrupteur rotatif de l'une quelconque des revendications 1 à 7, dans lequel l'enceinte d'interrupteur de dessous est couplée à l'enceinte d'interrupteur de dessus pour former une enceinte d'interrupteur assemblée, dans lequel l'enceinte d'interrupteur assemblée a une hauteur d'enceinte maximum telle que mesurée depuis la surface de dessus de l'enceinte d'interrupteur de dessus jusqu'à une surface la plus basse de l'enceinte d'interrupteur de dessous, dans lequel la hauteur d'enceinte maximum est entre environ 12,00 mm et environ 14,00 mm.

9. Interrupteur rotatif de la revendication 8, dans lequel l'interrupteur rotatif a une largeur d'interrupteur maximum et une longueur d'interrupteur maximum, dans lequel la largeur d'interrupteur maximum est une largeur maximum de l'enceinte d'interrupteur assemblée, dans lequel la largeur d'interrupteur maximum est entre environ 37,00 mm et environ 40,00 mm, dans lequel la longueur d'interrupteur maximum est une longueur maximum de l'enceinte d'interrupteur assemblée, dans lequel la longueur d'interrupteur maximum est entre environ 61,00 mm et 65,00 mm.

10. Interrupteur rotatif de l'une quelconque des revendications 1 à 9, dans lequel la PCB comprend une découpe définie le long d'un bord de la PCB, dans lequel le potentiomètre rotatif est monté à l'intérieur de la découpe de manière telle qu'au moins une portion supérieure du potentiomètre rotatif est positionnée au-dessus d'une surface de dessus de la PCB et une portion inférieure du potentiomètre rotatif est positionnée en dessous d'une surface de dessous de la PCB.

11. Interrupteur rotatif de l'une quelconque des revendications 1 à 10, dans lequel l'arbre claveté est couplé à un composant curseur du potentiomètre rotatif, dans lequel le composant curseur est couplé électriquement à une borne variable du potentiomètre rotatif, dans lequel le composant curseur entre en rotation en réponse à une rotation de l'arbre claveté, et dans lequel une résistance du potentiomètre rotatif varie en réponse à une rotation du composant curseur.
